# EUROPEAN PATENT SPECIFICATION

(11) **EP 4 384 759 B1**
(45) Date of publication and mention of the grant of the patent: **15.07.2026**
(21) Application number: 22854837.6
(22) Date of filing: 11.08.2022
(51) Int. Cl.: F25B 15/14, B01D 53/26, F25B 37/00, B01D 53/18, F25B 15/06

(54) **LIQUID DESICCANT ABSORPTION CHILLER**
ABSORPTIONSKÜHLER FÜR FLÜSSIGES TROCKNUNGSMITTEL
REFROIDISSEUR D'ABSORPTION DE DÉSHYDRATANT LIQUIDE

(30) Priority: 13.08.2021 US 202163233083 P
(43) Date of publication of application: 19.06.2024
(60) Divisional application: 26184571.3
(73) Proprietor: Nortek Air Solutions Canada, Inc., Saskatoon, Saskatchewan S7K 1V7 (CA)
(72) Inventor: GE, Gaoming, Saskatoon, Saskatchewan S7H 4X4 (CA); LEPOUDRE, Philip Paul, Saskatoon, Saskatchewan S7H 4A4 (CA)
(74) Representative: Marks & Clerk LLP
(86) International application number: PCT/CA2022/051226
(87) International publication number: WO 2023/015394

(56) References cited:
- US-A1- 2013 298 590
- US-A1- 2013 298 590
- US-A1- 2014 150 656
- US-A1- 2014 150 656
- US-B2- 8 769 971

## Description

### BACKGROUND

There are many applications where cooling is critical, such as, for example, data centers. A data center usually consists of computers and associated components working continuously (24 hours per day, 7 days per week). The electrical components in a data center can produce a lot of heat, which then needs to be removed from the space. Air-conditioning systems in data centers can often consume more than 20% of the total energy.

With the current data centers' air-conditioning systems and techniques and significant improvements in IT components operating conditions and processing capacity, servers can roughly operate at 50% of their capacity. This capacity limitation is due, in part, to the cooling systems not being able to cool the servers efficiently and the servers reach their high temperature limit before reaching their maximum capacity. High density data center cooling seeks to cool servers more effectively and increase the density of the data centers. Consequently, this will result in savings in data center operating cost and will increase the data center overall capacity.

The high density data center cooling can be achieved by using liquid cooling technologies to reject the heat at the server. Data center liquid cooling affects the data center energy consumption in two ways: (1) utilizing maximum server processing capacity and data center processing density which will result in lower cooling power consumption per kW of processing power in the data center, and (2) generally liquid-cooling systems are more energy efficient than data centers air-cooling systems. The liquid cooling technology can capture up to 100% of the heat at the server which can eliminate the need for data centers air-cooling systems. The data center liquid cooling can save up to 90% in data centers cooling costs and up to 50% in data centers operating costs. Also, data center liquid cooling can increase the servers processing density by up to 100% which can result in significant savings.

Evaporative cooling systems are used successfully in many applications, especially in dry climates. Direct evaporative coolers (DEC) can be simple in design and efficient, compared to, for example, vapor compression systems. However, conventional DECs can have some drawbacks. The supply air temperature coming out of the cooler may be challenging to control and is dependent on the outdoor air temperature and humidity level. The supply air may be excessively humid. These systems need careful maintenance to ensure that bacteria, algae, fungi and other contaminants do not proliferate in the water system and transfer into the supply air stream. Since these systems utilize direct contact between the evaporating liquid water and supply air, carryover of contaminants into the air stream can occur, which can, in turn, lead to reduced indoor air quality, odors and "sick building syndrome." Also, buildup of mineral deposits in the unit and on the evaporative pads can reduce performance and require maintenance.

Indirect evaporative coolers address the humidity problem but typically operate at lower wet bulb efficiencies. State-of-the-art dew-point evaporative coolers can deliver lower cooling temperatures than conventional direct or indirect evaporative systems and can maintain cooling power to higher outdoor wet bulb temperatures. However, all evaporative cooling technologies lose cooling performance as the working air humidity rises and cannot be used in humid climates without supplemental (usually vapor compression) cooling equipment. The water usage efficiency of evaporative cooling systems also varies widely depending on the system design and control characteristics. The water usage of evaporative coolers can be a problem, or at least a perceived problem. For example, large scale data centers may consume large quantities of potable water. Moreover, for those locations in which evaporative cooling works best (dry climates), the water demand may not be sustainable.

Absorption chillers are increasingly being adopted for comfort and process cooling, especially when waste heat is available. These systems have been successfully commercialized for larger scale applications and can be a good alternative to mechanical cooling in integrated building designs where the required technical and maintenance support is available. Single-effect absorptions chillers have a COP less than one, so significant quantities of heat are required to drive the system. Current absorption chiller designs are intended to replace electric chillers and deliver comparable cooling temperatures (40°F - 50°F; 4.4°C - 10°C). This requires the use of specialized materials (alloy metals), vacuum vessels, multiple heat exchangers, relatively high grade heat input for the generator, control methods to prevent crystallization, etc. Higher efficiency double and triple effect designs are increasingly complex and expensive. The complexity, cost and maintenance requirements of absorption systems may limit their widespread acceptance as an alternative to mechanical cooling, especially in light commercial and residential applications.

There remains a need for alternative cooling technologies for comfort conditioning applications, which can largely replace mechanical cooling. The growing awareness of environmental impacts, electricity consumption and increasing regulatory pressure on refrigerants are pressing challenges for current HVAC cooling equipment. There is a need for a commercially viable design which meets requirements for capital and installation costs, operating costs, performance, reliability, size/weight restrictions, etc., while avoiding the creation of any new resource utilization problems, such as excessive water or energy consumption. Ideally, The design should have good cooling performance and compactness, make use of low cost materials, and avoid the use of any environmentally harmful or toxic substances. From a thermodynamic perspective, the system should operate near atmospheric pressures with low grade heat input, employ moderate temperature changes and exchange fluxes to minimize irreversibility in the system and improve second law efficiency.

US 2014/150656 A1 discloses an absorber-evaporator according to the preamble of claim 1 and describes a heat exchanger for capturing water vapor from an air stream while simultaneously cooling the air stream. A high temperature, high humidity air stream enters a series of membrane plates that cool and dehumidify the air stream. The cool, dry, leaving air is supplied to a space such as a space in a building. A desiccant is supplied through supply ports to provide a uniform desiccant film flow across the membrane plates. A cooling fluid is supplied through ports to provide uniform cooling fluid flow inside the membrane plates.

US 8,769,971 B2 describes an indirect evaporative cooler that includes a first flow channel for inlet supply air and a second flow channel adjacent the first for exhaust air. The first and second flow channels are defined in part by sheets of a membrane permeable to water vapor such that mass is transferred as a vapor through the membrane from the inlet supply air to a contained liquid desiccant for dehumidification and also to the exhaust air as heat is transferred from the inlet supply air to the liquid coolant. A separation wall divides the liquid desiccant and the coolant but allows heat to be transferred from the supply air to the coolant which releases water vapor to the counter or cross flowing exhaust air.

### SUMMARY

In accordance with the invention, there is provided an absorber-evaporator as recited by claim 1.

The present inventors recognize, among other things, an opportunity for improved performance in providing cooling to a heat load using a conditioning system including a liquid desiccant absorption chiller (LDAC) system in accordance with examples of this application. For example, LDAC systems (also referred to as LDAC units) in accordance with this disclosure can be employed in combination with an evaporative cooler system to cool a heat load from, e.g., an enclosed space or one or more heat-generating devices. In an example, the conditioning system including an example LDAC unit cools water (or other type of cooling liquid). The cooled water is conveyed from the conditioning system to a separate liquid or air cooling system that cools the heat load. The LDAC unit of the present disclosure can supplement or replace other trim chilling components of such a conditioning system to, e.g., improve thermal performance and/or functionality of the system at or near peak conditions (i.e., hot and/or humid outdoor air conditions).

Several conditioning systems can incorporate the LDAC unit of the present disclosure. In an example, the conditioning system can include an evaporative cooler to evaporatively cool a cooling liquid using scavenger air and the LDAC unit can provide additional liquid cooling under certain operating and/or environmental conditions. The evaporative cooler may be combined with a dry coil disposed downstream of the evaporative cooler. The dry coil (a type of liquid-to-air heat exchanger or LAHX) can also be configured to condition the cooling liquid using the scavenger air. In an evaporation mode, the evaporative cooler and the dry coil are both operating. The cooling liquid is evaporatively cooled in the evaporative cooler and delivered to the heat load. The cooling liquid that is delivered to and heated by the heat load is returned to a liquid inlet of the dry coil, which sensibly cools the liquid using the scavenger air exiting the evaporative cooler and delivers this pre-cooled cooling liquid to the liquid inlet of the evaporative cooler. In this evaporation mode, the cooling liquid can be delivered to the heat load directly from the evaporative cooler or from the evaporative cooler to the LDAC unit, and then from the LDAC unit to the heat load.

In an economizer mode of this example system, the evaporative cooler can be bypassed (and in some cases deactivated completely) and the scavenger air can be channeled directly through the dry coil, because, e.g., the outdoor air conditions are such that the dry coil can carry the requirements to the heat load without the evaporative cooler. The reduced-temperature water exiting the dry coil can be used for liquid cooling or air cooling for the heat load.

Such a conditioning system, whether in evaporation or economizer mode, can include or use an LDAC unit for supplying additional cooling to the cooling liquid. The LDAC unit can use liquid desiccant which can absorb water vapor in an absorber-evaporator from the cooling liquid through evaporation and thereby reduce the temperature of the cooling liquid. The LDAC unit can also include a regenerator to restore the concentration of at least a portion of the dilute desiccant exiting the absorber, prior to recirculating the desiccant back through the absorber. The regenerator can remove a portion of the water from the desiccant such that the regenerator can output concentrated liquid desiccant and distilled water, which distilled water can be used as makeup water for one or more components of a conditioning system and/or stored. The LDAC unit can also include or use a desiccant cooler which can pre-cool the liquid desiccant before it enters the absorber to, e.g., enhance absorption/evaporation of water vapor from and cooling of the cooling liquid.

As noted, LDAC units in accordance with this disclosure include an absorber-evaporator (AE) device to cool a cooling liquid. In some examples according to this disclosure, the AE device can include adjacent liquid panels separated by an air or vacuum chamber. The air or vacuum chamber can also be referred to herein as a condensation chamber. Liquid desiccant circulating through the LDAC flows through one of the adjacent liquid panels, which includes a frame enclosed (to the air or vacuum chamber) by a permeable membrane. The cooling liquid flows through the other of the adjacent liquid panels, which can also include a frame enclosed (to the air or vacuum chamber) by a permeable membrane. The permeable membranes of each of the adjacent liquid channels can be structured and configured to be permeable to water, but not to other constituents that may be present in the liquids. Thus, generally anything in the liquid desiccant and cooling liquid in a gas phase can pass through the membranes and generally anything in a liquid or solid phase cannot pass through the membranes. As the cooling liquid flows through the evaporator portion of the AE device, water vapor can evaporate from the cooling liquid and migrate across the membranes and air-gap cell/chamber and into the liquid desiccant, thereby providing evaporative cooling to the cooling liquid.

An example absorber-evaporator according to this disclosure includes a cooling liquid channel through which a cooling liquid is configured to flow, a liquid desiccant channel through which a liquid desiccant is configured to flow, an air-gap cell, a first permeable membrane, and a second permeable membrane. The air-gap cell is disposed between the cooling liquid channel and the liquid desiccant channel. The first permeable membrane is disposed between the liquid desiccant channel and the air-gap cell. And the second permeable membrane is disposed between the second liquid channel and the air-gap cell.

Example conditioning systems according to the present application can employ, *inter alia,* a Liquid-to-Air Membrane Energy Exchanger (LAMEE) as an evaporative cooler. Such systems employing a LAMEE may reduce cooling energy consumption compared to conventional air cooling data centers techniques. Additionally, such cooling systems including a LAMEE may be significantly smaller in size and lighter compared to other direct evaporative coolers (DEC), including air-cooling DECs. Such systems may also reduce the water consumption in comparison with other systems including different types of evaporative coolers and may reduce the operating cost of the data center (or other heat load).

This overview is intended to provide an overview of subject matter in the present application. It is not intended to provide an exclusive or exhaustive explanation of the invention. The detailed description is included to provide further information about the present application.

### BRIEF DESCRIPTION OF THE DRAWINGS

In the drawings, which are not necessarily drawn to scale, like numerals may describe similar components in different views. Like numerals having different letter suffixes may represent different instances of similar components. The drawings illustrate generally, by way of example, but not by way of limitation, various embodiments discussed in the present disclosure.
FIG. 1 schematically depicts an example liquid desiccant absorption chiller in accordance with this invention.
FIG. 2 depicts an example absorber-evaporator (AE) in accordance with examples of this invention.
FIG. 3 schematically depicts an example conditioning system in accordance with this invention.
FIG. 4A schematically depicts another example conditioning system in accordance with this invention.
FIG 4B. schematically depicts another example conditioning system in accordance with this invention.
FIG. 5 schematically depicts another example conditioning system in accordance with this invention.
FIG. 6 schematically depicts schematically depicts another example conditioning system in accordance with this invention.
FIG. 7 schematically depicts another example conditioning system in accordance with this invention.
FIG. 8 schematically depicts schematically depicts another example conditioning system in accordance with this invention.
And FIG. 9 schematically depicts schematically depicts another example conditioning system in accordance with this invention.

### DETAILED DESCRIPTION

The present invention relates to conditioning systems and methods for providing cooling to a heat load. The heat load can be any type of device or system that generates heat. More particularly, the present application relates to systems and methods for providing cooling using a liquid-desiccant based absorption refrigeration unit as a supplemental chiller for a primary conditioning system.

Thermal performance of a conditioning system can depend, at least in part on climate and outdoor air conditions of the system. This is because outdoor air is used by the conditioning system to provide cooling to the heat load, and, as the outdoor air approaches increasing wet bulb temperatures (e.g., in hot or humid climates), several components of the system can require supplemental cooling or dehumidification to maintain sufficient provision of cooling to the heat load.

One approach to supplemental cooling, such as to counteract the effects of peak conditions on a conditioning system, is to employ a vapor compression cycle mechanical chiller using synthetic refrigerants to produce trim (supplemental) cooling to a primary cooling system or component. One challenge with this approach, however, is that vapor compression cycle trim chillers require relatively large amounts of electricity to operate and are relatively inefficient. In view of the challenges with other types of trim cooling systems, example absorption refrigeration (AR) units in accordance with this disclosure can be included as a component of a conditioning system to provide supplemental/trim cooling that is relatively energy efficient and that can require less water to operate.

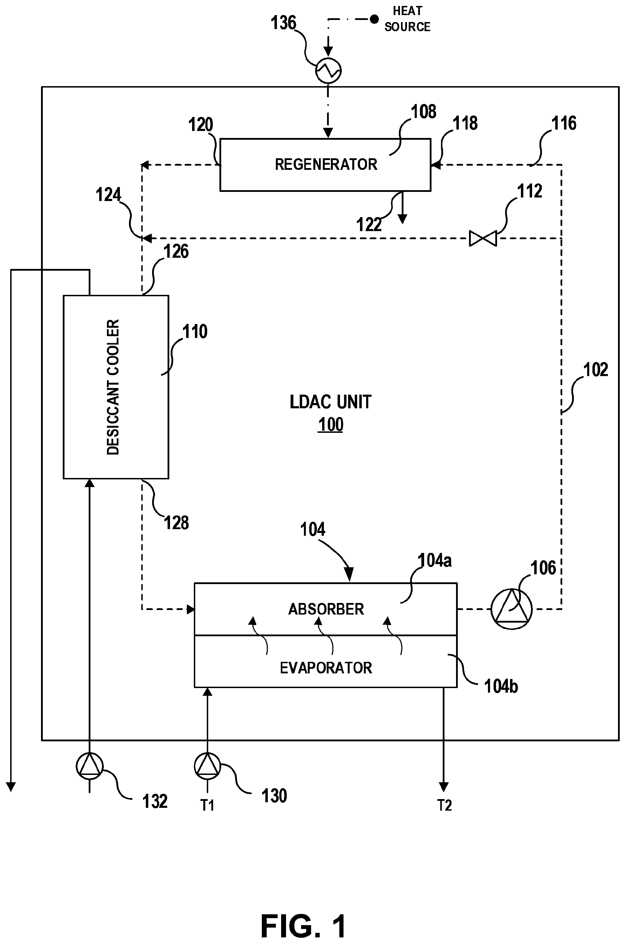

FIG. 1 schematically depicts an example LDAC system or unit 100 in accordance with this disclosure. LDAC unit 100 can be employed for a variety of practical applications and in combination with various other HVAC components and/or systems. Generally speaking, LDAC unit 100 functions to take in a cooling liquid at a first, inlet temperature, circulate the cooling liquid through the components of LDAC unit 100 to cool the liquid to a second, cooler (relative to the inlet temperature) outlet temperature. The cooled liquid exiting LDAC unit 100 can be delivered directly to a heat load or to another conditioning system that employs the cooled liquid to cool a heat load, as examples.

Referring to FIG. 1, example LDAC unit 100 includes first desiccant circuit 102 in liquid communication with absorber-evaporator 104 (hereinafter AE 104), desiccant pump 106, desiccant regenerator 108, desiccant cooler 110, and valve 112. In some examples, as depicted in FIG. 1, the first desiccant circuit 102 can be in liquid communication with a valve 112 which can control distribution of the liquid desiccant exiting AE 104 to regenerator 108 and bypassing regenerator 108 to desiccant cooler 110. The AE 104 includes absorber portion 104a and evaporator portion 104b. The liquid desiccant flows through absorber portion 104a and the cooling liquid flows through evaporator portion 104b. AE 104 evaporatively cools the cooling liquid as water in the cooling liquid evaporates inside AE 104 and is absorbed by the liquid desiccant. The temperature, T2, of the cooling liquid exiting evaporator portion 104b is lower than the temperature, T1, of the cooling liquid entering evaporator portion 104b. Additionally, the temperature of the liquid desiccant flowing through absorber portion 104a rises from inlet to outlet, but the concentration of liquid desiccant reduces and becomes diluted. Thus, AE 104 can function to transfer water vapor from the cooling liquid to the liquid desiccant, which can lower the temperature of the cooling liquid as a result of evaporative cooling.

AE 104 can include a number of different types of absorber-evaporator devices/systems. For example, the liquid desiccant can flow through solution channels in absorber portion 104a of AE 104 and the cooling liquid in evaporator portion 104b can be sprayed or otherwise distributed on the external surfaces of the solution channels for evaporative cooling. In such examples, the solution channels can include liquid desiccant panels each including a frame enclosed by permeable membranes on opposite sides of the frame, or a hollow fiber membrane tube bank, as examples. AE 104 can be structured and configured for different liquid flow configurations including, e.g. parallel, cross, and counter flow between the liquid desiccant solution and the cooling liquid.

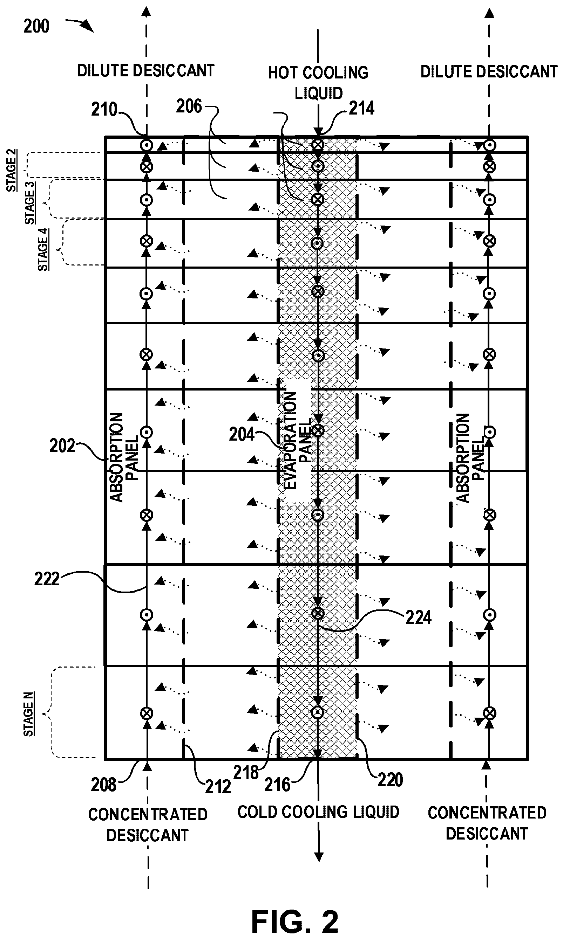

As described in greater detail with reference to FIG. 2, an example AE 104 in accordance with examples of this disclosure can include adjacent liquid panels separated by an air or vacuum chamber. The liquid desiccant flows through one of the adjacent liquid panels, which includes a frame enclosed (to the air or vacuum chamber) by a permeable membrane. The cooling liquid flows through the other of the adjacent liquid panels, which can also include a frame enclosed (to the air or vacuum chamber) by a permeable membrane. The permeable membranes of each of the adjacent liquid channels can be structured and configured to be permeable to water, but not to other constituents that may be present in the liquids. Thus, generally anything in the liquid desiccant and cooling liquid in a gas phase can pass through the membranes and generally anything in a liquid or solid phase cannot pass through the membranes.

Such membranes can include porous, micro-porous, non-porous, and selectively permeable membranes, as examples. In examples, the membranes of example absorber-evaporator devices in accordance with this disclosure can be a micro-porous structure membrane formed as a thin film of a low surface energy polymer such as PTFE, polypropylene or polyethylene. The hydrophobic membrane resists penetration by the liquid due to surface tension, while freely allowing the transfer of gases, including water vapor, through the membrane pores. In examples, the membranes can be between about 20 to about 100 microns thick with a mean pore size of 0.1-0.2 micron.

In operation of examples absorber-evaporators as summarily described above and in more detail with reference to FIG. 2, as cooling liquid flows from through the evaporator portion (e.g., one or more liquid panels enclosed by permeable membranes), water vapor can evaporate from the cooling liquid and migrate across the membrane and into the liquid desiccant, thereby providing evaporative cooling to the cooling liquid. As noted above, the temperature, T1, of the cooling liquid entering the evaporator portion is higher than the temperature, T2, of the cooling liquid exiting the evaporator portion. Additionally, in at least some cases, the temperature of the liquid desiccant entering the absorber portion can be lower than the cooling liquid entering the evaporator portion. The vapor pressure of the cooling liquid can be relatively high, and a significant vapor pressure gradient can exist across the membrane of the liquid panel through which the cooling liquid flows. Similarly, the vapor pressure of the liquid desiccant can be relatively low, and a significant vapor pressure gradient can exist across the membrane of the liquid panel through which the liquid desiccant flows.

In such example absorber-evaporators, water vapor can migrate across the membrane of the cooling liquid panel(s) and into the concentrated desiccant without requiring supplemental energy to be applied to the process. In examples where the cooling liquid has a high vapor pressure, such as liquid water, the cooling liquid can enable example absorber-evaporators in accordance with this disclosure to use relatively low concentration and/or inexpensive liquid desiccants, including, e.g., magnesium chloride (MgCl2) or calcium chloride (CaCl2). Using a cooling liquid with a high vapor pressure can also reduce the load on regenerator 108 to maintain the required concentration of the desiccant and thereby can reduce energy consumption. The ability of absorber-evaporators in accordance with this disclosure to use relatively low concentration liquid desiccants to absorb water vapor from the cooling liquid in this manner can be particularly beneficial in terms of the energy efficiency of LDAC units including such absorber-evaporators within a larger cooling/conditioning system. For instance, a relatively low load on regenerator 108 can allow for an energy input 136 (e.g., a heater) to regenerator 108 to be a lower grade source, e.g., recycled heat or waste heat from another component of a conditioning system.

Referring again to FIG. 1, LDAC unit 100 includes desiccant regenerator 108 located downstream first desiccant circuit 102 (in the direction of flow of liquid desiccant) from AE 104. Generally, regenerator 108 functions to restore the concentration of the liquid desiccant after it collects water vapor from the cooling liquid in AE 104. Regenerator 108 can be part of second desiccant circuit 116 that can be in liquid connection with first desiccant circuit 102. Regenerator 108 and second desiccant circuit 116 can be part of a regeneration system that can be configured to regenerate the liquid desiccant before the desiccant is recirculated back to the AE 104 through desiccant cooler 110. The desiccant from AE 104 can pass through a first modulating valve 112 that can be controlled based on, at least in part, the latent or sensible cooling load of a larger conditioning system in which LDAC unit 100 is included and/or ambient environmental conditions. The modulating valve 112 can also be controlled based on, at least in part, the desired concentration of liquid desiccant flowing back to the AE 104. First modulating valve 112 can control the distribution of desiccant to regenerator 108 and bypassing regenerator 108 directly to desiccant cooler 110.

Other and/or additional means can be used in addition to or as an alternative to the valve 112 to control a flow of desiccant from the AE 104 to regenerator 108 and directly to cooler 110, bypassing regenerator 108. As an example, a second desiccant pump can be included in LDAC unit 100 to pump desiccant to regenerator 108 such that desiccant pump 106 drives desiccant flow directly to the desiccant cooler 110, bypassing regenerator 108; the operation of the second desiccant pump can thereby control how much, if any, desiccant is transported directly to desiccant cooler 110, bypassing regenerator 108, and indirectly how much desiccant is transported through regenerator 108 for regeneration therein.

Regenerator 108 is structured and configured to receive dilute desiccant from AE 104, draw water out of the desiccant, and channel the concentrated (regenerated/restored) desiccant and recovered water out of the device. For example, regenerator 108 can be configured to receive the liquid desiccant at regenerator inlet 118 and separate the water and desiccant into a concentrated desiccant stream, which exits regenerator 108 at regenerator outlet 120, and a water stream, which exits the regenerator 108 at recovered water outlet 122. The water recovered by regenerator 108 can be used as a pure water supply by other components of the conditioning system such as to reduce overall water consumption of the system, and/or stored in a tank or other reservoir. Regenerator 108 can include energy input 136 to facilitate such separation of water and desiccant, e.g. by heating the liquid desiccant within a portion of the regenerator 108. In some examples, energy input 136 can be recycled or waste heat from another component of a larger conditioning system. In other examples, energy input 136 can be solar heat, heat or steam provided by a boiler, a heat exchanger, or a relatively high-grade heat source to help improve the thermal performance and water recovery efficiency of regenerator 108. Additionally, in examples, depending on a volume of water available for separation from the liquid desiccant, the recovered water exiting the regenerator 108 can reduce or eliminate an external water supply necessary for other components of the conditioning system.

The dilute desiccant exiting AE 104 can have a first desiccant concentration C1. The desiccant at the first concentration C1 can be regenerated in regenerator 108 such that a second concentration C2 of the desiccant exiting regenerator 108 can be markedly greater than the first concentration C1. In examples in which first modulating valve 112 is employed to divert some of the dilute desiccant around regenerator 108, the dilute desiccant, still at the first concentration C1, can be combined at junction 124 with the concentrated desiccant existing regenerator 108 at the second concentration C2 to create a mixed concentrated desiccant with a third concentration C3 that enters desiccant cooler 110. In examples, the junction 124 can include or use a tank or other reservoir for mixing bypassed desiccant with desiccant from regenerator 108.

Regenerator 108 can include a variety of devices structured and configured to separate liquid water from the liquid desiccant. For example, regenerator 108 can be a thermally driven brine concentration device/system. In examples, regenerator 108 is a vacuum multi-effect membrane distillation device, which is configured to employ heat to distill the desiccant solution flowing there through. Regenerator 108 can also include other types of devices, including, for example, electro dialysis, reverse osmosis (RO) filtration, a gas boiler with condenser, a vacuum assisted, multi-stage flash, or other membrane distillation devices other than a vacuum multi-effect membrane distillation device.

The type of energy input 136 to regenerator 108 can include, for example, electrical power, mechanical power, or heat. The type of energy input 136 depends on the technology used for regeneration of the liquid desiccant. Although the regenerator 108 is shown as a single unit in FIG. 1, the regenerator 108 can represent more than one device. For example, the regeneration system can include a heat recovery unit upstream of the regeneration or separation unit.

The liquid desiccant traveling through desiccant circuit 102 can increase in temperature in passing through AE 104 and can also increase in temperature in passing through regenerator 108. LDAC unit 100 includes desiccant cooler 110 located downstream of regenerator 108 to cool the liquid desiccant to a predetermined temperature such that it is suitable for recirculation back into AE 104. The predetermined temperature of the liquid desiccant entering AE 104 can depend, e.g., on the cooling capacity of AE 104 and the required set point temperature of the cooling liquid exiting AE 104, in the example of FIG. 1, T2. In examples according to the present disclosure in which AE 104 includes liquid desiccant and cooling liquid panels enclosed by permeable membranes and separated by an air-gap or vacuum chamber(s), Additionally, the predetermined (required/target) temperature of the liquid desiccant entering AE 104 can depend in part upon the concentration of the liquid desiccant and the vapor pressure of the cooling liquid.

Desiccant cooler 110 is structured and configured to cool the liquid desiccant flowing therethrough from cooler inlet 126 to cooler outlet 128. Desiccant cooler 110 can be a variety of devices configured to cool the liquid desiccant, including, generally, liquid-to-air or liquid-to-liquid heat exchangers (LAHX and LLHX, respectively), chillers, dry coolers, cooling towers, adiabatic coolers, or any other type of evaporative cooler or hybrid cooler, or a combination thereof. In examples, desiccant cooler 110 can circulate air to cool the liquid desiccant, e.g., using outdoor air or another source of air at an appropriate temperature to cool the desiccant. In other examples, including the example of FIG. 1, desiccant cooler 110 circulates a cooling liquid to lower the temperature of the liquid desiccant. In examples, the cooling liquid can be supplied, e.g., from a fluid cooler, a geothermal cooling source such as a ground source or lake, or a separate evaporative cooler, cooling tower, or chiller.

In the example of FIG. 1 and other examples in which desiccant cooler 110 uses a liquid to cool the desiccant, the cooling liquid circulating through desiccant cooler 110 can be a second cooling liquid from a different source than and generally separate from the (first) cooling liquid circulating through AE 104. Additionally, the cooling liquid circulating through desiccant cooler 110 can be same cooling liquid circulating through AE 104

In operation and use, liquid desiccant can be cycled through LDAC unit 100, can cool a cooling liquid from T1 to T2, which cooled liquid is then delivered to a heat load to which LDAC unit 100 is connected. The liquid desiccant can be cycled through LDAC unit 100 at a predetermined flow rate using the desiccant pump 106. Additionally, the liquid desiccant can be cycled through LDAC unit 100 at a variable flow rate based on a system load of a larger conditioning system to which LDAC unit 100 is connected/in which LDAC unit is included and/or ambient environmental conditions. The concentration of the liquid desiccant entering AE 104 can be modulated via valve 112 (or other means) to provide sufficient concentration levels of the liquid desiccant for cooling the cooling liquid to a set point temperature. Additionally, the temperature of the liquid desiccant entering AE 104 can be modulated by varying the amount of cooling provided by desiccant cooler 110. The concentration and/or temperature of the liquid desiccant entering AE 104 can be modulated to vary moisture transfer between desiccant and cooling liquid and also to vary the temperature change (T2-T1) of the cooling liquid across through AE 104. More generally, the concentration and/or temperature of the liquid desiccant entering AE 104 can be modulated to vary the amount of liquid cooling applied to the cooling liquid by LDAC unit 100 for various purposes and in combination with various other conditioning devices and/or systems.

The routing of cooling liquid through AE 104 and desiccant cooler 110 can be implemented using a variety of types and number of devices or other techniques, including various number and types of valves, tanks or other reservoirs, and pumps. In the example of FIG. 1, first pump 130 transmits the cooling liquid through AE 104 and second pump 132 transmits the cooling liquid through desiccant cooler 110.

FIG. 2 depicts example absorber-evaporator (AE) 200 in accordance with examples of this disclosure. AE 200 includes absorption panels 202, evaporation panel 204, and air or vacuum chambers 206 interposed between adjacent absorption and evaporation panels. In operation of AE 200, as cooling liquid flows from through evaporator panel 204, water vapor evaporates from the cooling liquid and migrates across membrane 218, chamber 206, and membrane 212 and into the liquid desiccant in absorption panel 202, thereby providing evaporative cooling to the cooling liquid. In the example of FIG. 2, AE 200 includes one evaporation panel 204 and two absorption panels 202 with two chambers 206 between the evaporation panel and absorption panels. However, absorber-evaporators in accordance with this disclosure can include a stack of more absorber panel-chamber-evaporator panel groups than that depicted in the example of FIG. 2.

Absorption panels 202 and evaporation panel 204 can be polymer panels formed of plastics suitable for use in conditioning systems. Each of panels 202 and 204 can define one or more liquid flow channels enclosed by a permeable membrane. For example, absorption panel 202 includes absorber inlet 208, absorber outlet 210, and first permeable membrane 212. And, evaporation panel includes evaporator inlet 214, evaporator outlet 216, second permeable membrane 218, and third permeable membrane 220. In examples in which an absorber-evaporator in accordance with this disclosure included more a stack of more absorber panel-chamber-evaporator panel groups, each absorber and evaporator panel includes two permeable membranes on opposite faces of and enclosing the liquid channel or channels defined by the panel.

Concentrated, relatively cold liquid desiccant is supplied to AE 200 via absorber inlet 208 and passed through one or more liquid channels in absorption panel 202 to absorber outlet 210. Liquid desiccant exiting absorption panel 202 at absorber outlet 210 can be less concentrated than the liquid desiccant entering the absorption panel at absorber inlet 208 as water in the cooling liquid evaporates inside AE 200 and is absorbed by the liquid desiccant to cool the cooling liquid.

Relatively hot cooling liquid is supplied to AE 200 via evaporator inlet 214 and passed through the evaporation panel 204 to evaporator outlet 216. The relatively hot cooling liquid can lose heat and water vapor in passing from evaporator inlet 214 to evaporator outlet 216 and exits AE 200 as relatively cooled cooling liquid at outlet 216.

The liquid channel or channels of absorption panel 202 are enclosed by first vapor permeable membrane 212 located between absorption panel 202 and air-gap chamber 206. The liquid channels of absorption panel 202 can be structured and configured to direct desiccant from inlet 208 to outlet 210 along a variety of flow paths. As indicated in FIG. 2, flow path 222 of absorption panel 202 directs the desiccant through the panel in two directions, up and down (in and out of the page depicting the view of FIG. 2) and from inlet 208 to outlet 210 in a serpentine path. Evaporation panel 204 includes a similar serpentine flow path 224 in the opposite direction as the flow through absorption panels 202. However, in other examples according to this disclosure, evaporation and absorption panel flow paths can be in the same direction from respective inlets to outlets. Also, absorption panels 202 and evaporation panel 204 can include multiple serpentine, parallel, interdigitated, or other flow paths through multiple liquid channels.

As noted, AE 200 includes air or vacuum chambers 206. Chambers 206 can function to reduce sensible heat transfer between evaporation panel 204 and absorption panels 202 and to improve vapor (mass) transfer across the permeable membranes of the panels, e.g. first membrane 212 and second membrane 218. Decreased (e.g., in the case of air-gap chambers) or negative (e.g., in the case of vacuum-gap chambers) air pressure in chambers 206 can be maintained continuously or periodically during operation of AE 200. The relatively hot cooling liquid entering AE 200 can have a significantly higher vapor pressure than the liquid desiccant flowing through the device. This can create a vapor pressure gradient across, e.g., first membrane 212 and second membrane 218, and also across air-gap chamber 206 located therebetween. As hot cooling liquid flows from evaporator inlet 214 to evaporator outlet 216, water vapor migrates across, e.g. second membrane 218 and subsequently across first membrane 212 as a result of the vapor pressure gradient. Water vapor transfer from the cooling liquid to the liquid desiccant evaporative cools the cooling liquid. As such, the temperature of the cooling liquid at evaporator outlet 216 is lower than the temperature of the cooling liquid at evaporator inlet 214.

To improve performance of AE 200 (and other absorber-evaporators in accordance with this disclosure), absorber panels 202, evaporation panel 204, and chambers 206 can include multiple stages or chambers in series relative to the flow of liquid through AE 200. In the case of chambers 206 the stages can be physically separated/isolated from one another and therefore one or more parameters in each of the chambers can be independently controlled. The performance of AE 200 in various conditions and in combination with various other conditioning systems can be enhanced by varying a number of parameters of the serial stages of the device. For example, pressure in different stages of the air or vacuum chambers 206 can be varied across AE 200 (i.e. from liquid inlet to liquid outlet). Additionally, the size of each stage can be varied, as is schematically depicted in the example of FIG. 2.

The permeable membranes of AE 200, e.g., first membrane 212, second membrane 218, and third membrane 220 can include porous, micro-porous, non-porous, and selectively permeable membranes, as examples. In examples, the membranes can be a micro-porous structure formed as a thin film of a low surface energy polymer such as PTFE, polypropylene or polyethylene. The hydrophobic membrane resists penetration by the liquid due to surface tension, while freely allowing the transfer of gases, including water vapor, through the membrane pores. In examples, the membranes can be between about 20 to about 100 microns thick with a mean pore size of 0.1-0.2 micron.

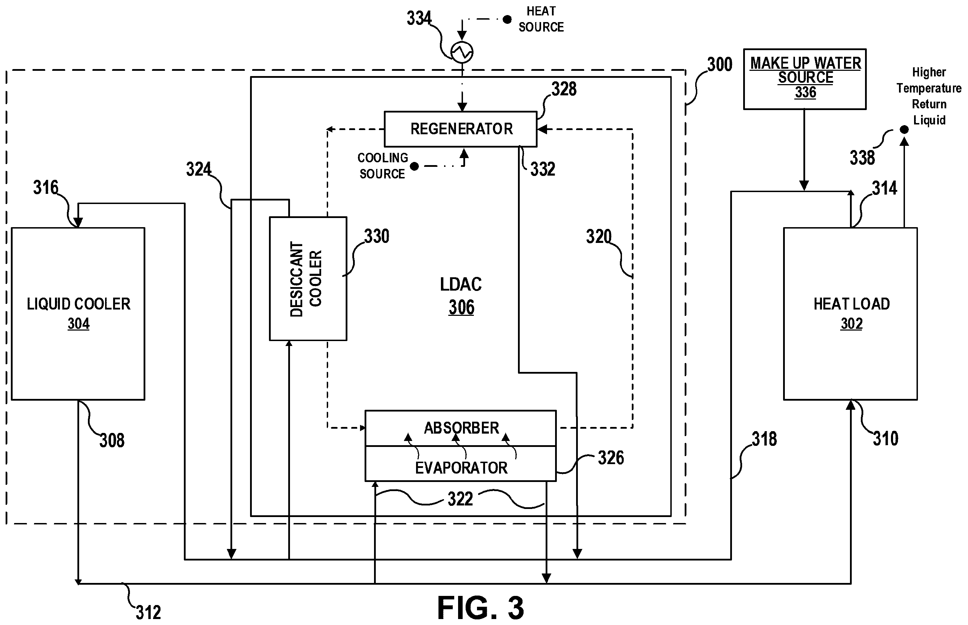

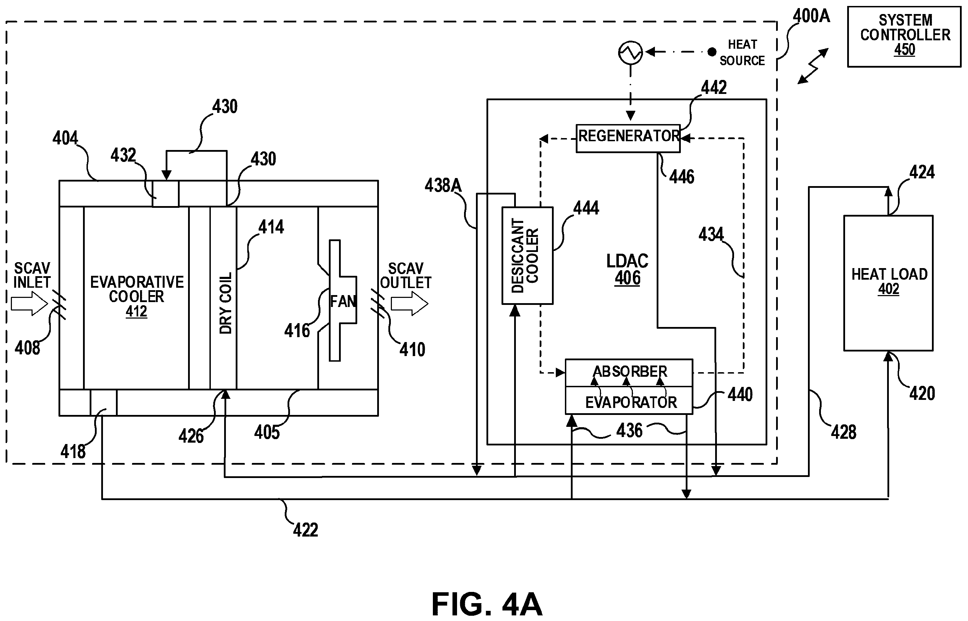

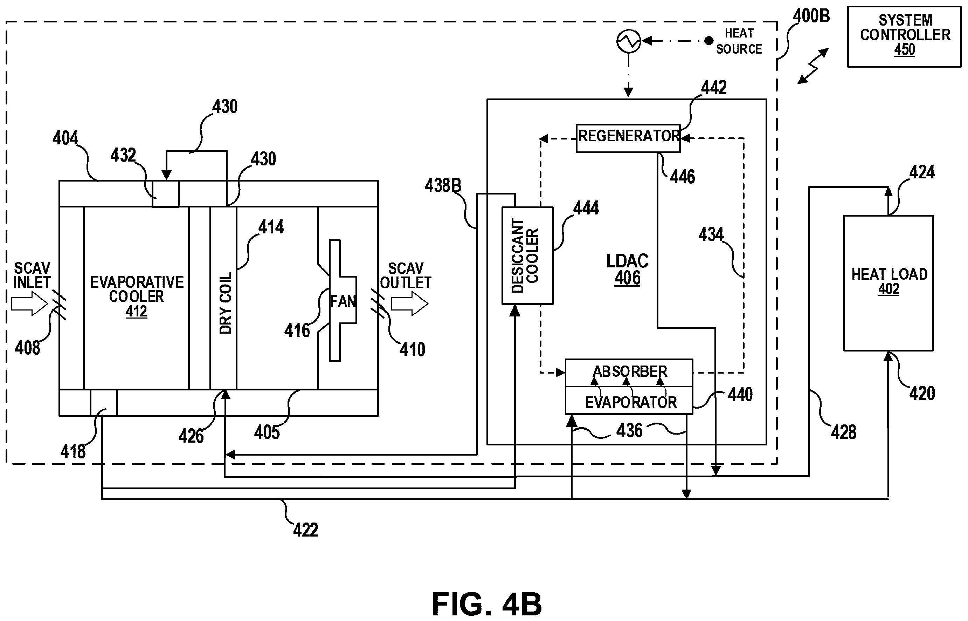

FIG. 3 schematically depicts example conditioning system 300 structured, arranged, and configured to deliver cooled liquid to heat load 302. Conditioning system 300 includes liquid cooler (LC) 304 fluidically connected to LDAC 306. LC 304 can be an HVAC system including a variety of components including, e.g., various types of liquid-to-liquid or liquid-to-air heat exchangers, as well as various types of evaporative coolers, as examples. In examples, LC 304 includes a liquid-to-air membrane energy exchanger (LAMEE) that is structured and configured to exchange latent and/or sensible energy between air and liquid flowing there through. In an example, a LAMEE evaporatively cools the cooling liquid using air via one or more pairs of adjacent liquid and air channels separated by a permeable membrane. A number of examples of a liquid cooler or liquid cooling system employed in combination with LDACs in accordance with examples of this disclosure are described in more detail with reference to FIGS. 4, 5, and 6.

In general, LC 304 is configured to cool a cooling liquid and deliver the cooling liquid to heat load 302, which can be an enclosed space such as a data center with heat generating electronic devices. The liquid supplied by LC 304 and, more generally, system 300 can be used by various air or liquid cooling systems to modulate conditions of the heat load. In some ambient conditions, LC 304 may not be capable of cooling the liquid sufficiently to carry the load of heat load 302. As such, LC 304 is fluidically coupled to LDAC 306, which can provide supplemental, sometimes referred to as trim cooling to the cooling liquid delivered to heat load 302.

LC 304, LDAC 306, and heat load 302 include and/or are connected by a number of liquid circuits. Liquid outlet 308 of LC 304 is connected to liquid inlet 310 of heat load 302 by cooling liquid supply circuit 312. Liquid outlet 314 of heat load 302 is connected to liquid inlet 316 of LC 304 by first cooling liquid return circuit 318. LDAC 306 includes liquid desiccant circuit 320 by which it recirculates liquid desiccant through the system, first cooling liquid circuit 322 by which it selectively circulates cooling liquid from LC 304 to heat load 302, and second cooling liquid circuit 324 by which it selectively circulates cooling liquid from heat load 302 back to LC 304. The routing of cooling liquid from LC 304 to heat load 302, from LC 304 to LDAC 306 to heat load 302, from heat load 302 to LC 304, from heat load 302 to LDAC 306 to LC 304 can be implemented using a variety of types and number of devices or other techniques, including various number and types of valves, tanks or other reservoirs, and pumps.

LDAC 306 includes absorber-evaporator (AE) 326, regenerator 328, and desiccant cooler 330. LDAC 306 can be substantially similar to LDAC unit 100 of the example of FIG. 1. The components, structures, configuration, functions, etc. of LDAC 306 can therefore be the same as or substantially similar to that described in detail above with reference to LDAC unit 100. Additionally, AE 326 can be substantially similar to AE 200 of the example of FIG. 2. The components, structures, configuration, functions, etc. of AE 326 can therefore be the same as or substantially similar to that described in detail above with reference to AE 200.

In examples, conditioning system 300 can cool the cooling liquid delivered to heat load 302 employing LC 304 without trim cooling from LDAC 306. Additionally, conditioning system 300 can cool the cooling liquid delivered to heat load 302 employing LC 304 with LDAC 306 providing supplemental or trim cooling to the cooling liquid coming from LC 304 and delivered by LDAC 306 to heat load 302. In examples in which conditioning system 300 cools the cooling liquid delivered to heat load 302 employing LC 304 without trim cooling from LDAC 306, the cooling liquid is cooled to a set point temperature required by heat load 302 and cold cooling liquid is delivered from outlet 308 of LC 304 to inlet 310 of heat load 302 via cooling liquid supply circuit 312. Additionally, in such cases, hot cooling liquid into which heat load 302 has rejected heat is returned to inlet 316 of LC 304 from outlet 314 of heat load 302 via cooling first liquid return circuit 318. Finally, in such cases, first cooling liquid circuit 322 and second cooling liquid circuit 324 are decoupled from the flow of cooling liquid through cooling liquid supply circuit 312 and cooling first liquid return circuit 318.

In examples in which conditioning system 300 cools the cooling liquid delivered to heat load 302 employing LC 304 with LDAC 306 providing supplemental or trim cooling to the cooling liquid coming from LC 304, first cooling liquid circuit 322 and second cooling liquid circuit 324 are coupled to the flow of cooling liquid through cooling liquid supply circuit 312 and first cooling liquid return circuit 318. The cooling liquid is cooled to a first temperature by LC 304 and is delivered from outlet 308 of LC 304 to AE 326 of LDAC 306 via cooling liquid supply circuit 312 and first cooling liquid circuit 322. LDAC 306, and, in particular, AE 326 cools the cooling liquid further to the set point temperature required by heat load 302 and cold cooling liquid is delivered from AE 326 to inlet 310 of heat load 302 via cooling liquid supply circuit 312 and first cooling liquid circuit 322. Additionally, in such cases, hot cooling liquid into which heat load 302 has rejected heat is delivered from outlet 314 of heat load 302 to desiccant cooler 330 via first cooling liquid return circuit 318 and second cooling liquid circuit 324. And, the further heated hot cooling liquid is delivered from desiccant cooler 330 to inlet 316 of LC 304 via second cooling liquid circuit 324 and first cooling liquid return circuit 318.

Similar to that previously described with respect to the LDAC unit 100, the LDAC unit 306 includes a regenerator 328 that is structured and configured to receive dilute desiccant from the AE 326, draw water out of the desiccant, and channel the concentrated (regenerated/restored) desiccant and recovered water out of the device. For example, regenerator 328 can be configured to receive the liquid desiccant at a regenerator inlet and separate the water and desiccant into a concentrated desiccant stream, which exits regenerator 326 at a regenerator outlet, and a water stream, which exits the regenerator 328 at recovered water outlet 332. The water recovered by regenerator 326 can be used as a pure water supply by other components of the conditioning system such as to reduce overall water consumption of the system, and/or stored in a tank or other reservoir. For example, as depicted in FIG. 3, recovered water exiting the recovered water outlet 332 can be directed to return to the first cooling liquid return circuit 318 as makeup water. In another example, recovered water exiting the recovered water outlet 332 can be directed to a reservoir to be, e.g., conditioned or stored before being injected back into conditioning system 300 as makeup water. Here, the water recovered by regenerator 328 is used to mitigate or eliminate net water loss from the first liquid cooling circuit 322 resulting from, e.g., evaporative cooling by the AE 326.

As previously described, regenerator 328 can include energy input 334 to facilitate separation of water and desiccant, e.g. by heating the liquid desiccant within a portion of the regenerator 328 to, e.g., help stimulate vapor transfer between fluids within the regenerator 328. In some examples, energy input 334 can be recycled or waste heat from another component of a larger conditioning system. In other examples, energy input 334 can be solar heat, heat or steam provided by a boiler, a heat exchanger, or a relatively high-grade heat source to help improve the thermal performance and water recovery efficiency of regenerator 328. The ability of absorber-evaporators in accordance with this disclosure to use relatively low concentration liquid desiccants to absorb water vapor from the cooling liquid in this manner can be particularly beneficial in terms of the energy efficiency of LDAC units including such absorber-evaporators within a larger cooling/conditioning system. For instance, a relatively low load on regenerator 328 can allow for an energy input 334 (e.g., supplied by a heat source) to regenerator 328 to be a lower grade source, e.g., recycled heat or waste heat from another component of a conditioning system.

Example energy inputs can be supplied by the heat source being recovered waste heat from the heat load 302. In one example, the cooling liquid exiting liquid outlet 314 can be supplied to the energy input 334 in order to reject heat to the regenerator 328. For example, the first cooling liquid return circuit 318 can be completely or partially supplied to the energy input 334 to reject heat to the regenerator 328 utilizing, e.g., a liquid to liquid heat exchanger (LLHX). In another example, the heat load 302 can include a second liquid outlet which supplies a second cooling liquid return circuit 338. The second cooling liquid return circuit 338 cycles cooling liquid at a second temperature greater than the temperature of the cooling liquid flowing through the first cooling liquid return circuit 318. This type of dual-circuit liquid return is prevalent in certain types of heat loads such as data centers where, e.g., heat is rejected to the cooling liquid from multiple distinct portions having differing cooling requirements and/or heat outputs. The liquid return circuit having the greater temperature (i.e., the second cooling liquid return circuit 338) can be supplied directly to the regenerator 328 to reduce the load on the energy input 334 before merging with the first cooling liquid circuit 318. Since the second cooling liquid return circuit 338 rejects heat to the regenerator 328 the temperature can be reduced prior to merging with the first cooling liquid return circuit 318 and or before being returned to the LC 304. Thus, the temperature difference between each of the first cooling liquid return circuit 318 and the second cooling liquid return circuit 338 can be mitigated prior to merging and before, e.g., evaporative cooling in the LC 304.

Example regenerators according to the present disclosure can also optionally include a cooling source (as depicted in FIG. 3) for cooling at least a portion of the liquid desiccant prior to regeneration. Here, the cooling source can be used alone or in combination with the energy input to facilitate separation of water and desiccant, e.g., by helping to stimulate vapor transfer between fluids within the regenerator 328. Example cooling sources can utilize, in some circumstances, the cooling liquid from any of circuits 318, 324, or 312 in combination with, e.g., an evaporative cooler or a dry cooler. Other cooling sources for the regenerator 328 can include, generally, liquid-to-air or liquid-to-liquid heat exchangers (LAHX and LLHX, respectively), chillers, dry coolers, cooling towers, adiabatic coolers, or any other type of evaporative cooler or hybrid cooler, or a combination thereof. The cooling source can directly cool components of the regenerator 328, e.g., a cooling plate within the regenerator 328. In other examples, the cooling source precools the liquid desiccant entering the regenerator 328.

Example conditioning systems of the present disclosure can include an optional makeup water source 336 for supplemental water supply to the cooling liquid. In an example, the makeup water source 336 is an atmospheric water harvesting unit which uses, e.g., a liquid desiccant dryer to recover water from the outside air or process air from a data center. Another example makeup water source 336 is blowdown water from a conditioning system. In some conditioning systems including evaporative cooling, blowdown water must be discharged in order to avoid excessive mineral buildup resulting from water vapor being separated out of utility water supplied to the system. This blowdown water can be distilled using, e.g., membrane distillation or reverse-osmosis filtration and used as makeup water. Other example makeup water sources 336 can be any other source of reclaimed water such as distilled or purified rainwater or environmental (e.g., river, lake) water.

A makeup water source is not specifically shown in all of the figures for the various conditioning systems described below. However, it is recognized that the other conditioning systems can include a makeup water source, which is similarly structured and configured and which operates similar to makeup water source 336.

FIG. 4A schematically depicts example conditioning system 400A structured, arranged, and configured to deliver cooled liquid to heat load 402. Conditioning system 400A includes liquid cooler (LC) 404 fluidically connected to LDAC 406. In this example, LC 404 includes scavenger air plenum 405 having air inlet 408 and air outlet 410, evaporative cooler (EC) 412, dry coil 414, and fan 416. Dry coil 414 may also be referred to as a recovery coil and is a type of liquid-to-air heat exchanger. In other examples according to this disclosure, another type of LAHX may be employed in lieu of a dry coil.

In general, LC 404 is configured to cool a cooling liquid and deliver the cooling liquid to heat load 402, which can be an enclosed space such as a data center with heat generating electronic devices. The liquid supplied by LC 404 and, more generally, system 400A can be used by various air or liquid cooling systems to modulate conditions of the heat load. In some ambient conditions, LC 404 may not be capable of cooling the liquid sufficiently to carry the load of heat load 402. As such, LC 404 is fluidically coupled to LDAC 406, which can provide trim cooling to the cooling liquid delivered to heat load 402.

LC 404, LDAC 406, and heat load 402 include and/or are connected by a number of liquid circuits. Liquid outlet 418 of EC 412 of LC 404 is connected to liquid inlet 420 of heat load 402 by cooling liquid supply circuit 422. Liquid outlet 424 of heat load 402 is connected to liquid inlet 426 of dry coil 414 of LC 404 by cooling liquid return circuit 428. And, liquid outlet 430 of dry coil 414 is connected to liquid inlet 432 of EC 412 by pre-cooling liquid circuit 433. LDAC 406 includes liquid desiccant circuit 434 by which it recirculates liquid desiccant through the system, first cooling liquid circuit 436 by which it selectively circulates cooling liquid from LC 404 to heat load 402, and second cooling liquid circuit 438A by which it selectively circulates cooling liquid from heat load 402 back to LC 404. The routing of cooling liquid from LC 404 to heat load 402, from LC 404 to LDAC 406 to heat load 402, from heat load 402 to LC 404, and from heat load 402 to LDAC 406 to LC 404 can be implemented using a variety of types and number of devices or other techniques, including various number and types of valves, tanks or other reservoirs, and pumps.

LDAC 406 includes absorber-evaporator (AE) 440, regenerator 442, and desiccant cooler 444. LDAC 406 can be substantially similar to LDAC unit 100 of the example of FIG. 1. The components, structures, configuration, functions, etc. of LDAC 406 can therefore be the same as or substantially similar to that described in detail above with reference to LDAC unit 100. Additionally, AE 440 can be substantially similar to AE 200 of the example of FIG. 2. The components, structures, configuration, functions, etc. of AE 440 can therefore be the same as or substantially similar to that described in detail above with reference to AE 200.

In examples, conditioning system 400A can cool the cooling liquid delivered to heat load 402 employing LC 404 without trim cooling from LDAC 406. Additionally, conditioning system 400A can cool the cooling liquid delivered to heat load 402 employing LC 404 with LDAC 406 providing trim cooling to the cooling liquid coming from LC 404 and delivered from LDAC 406 to heat load 402.

In examples in which conditioning system 400A cools the cooling liquid delivered to heat load 402 employing LC 404 without trim cooling from LDAC 406, the cooling liquid is cooled to a set point temperature required by heat load 402 and cold cooling liquid is delivered from outlet 418 of LC 404 to inlet 420 of heat load 402 via cooling liquid supply circuit 422. Additionally, in such cases, hot cooling liquid into which heat load 402 has rejected heat is returned to inlet 426 of dry coil 414 from outlet 424 of heat load 402 via cooling liquid return circuit 428. Finally, in such cases, first cooling liquid circuit 436 and second cooling liquid circuit 438A are decoupled from the flow of cooling liquid through cooling liquid supply circuit 422 and cooling liquid return circuit 428.

In examples in which conditioning system 400A cools the cooling liquid delivered to heat load 402 employing LC 404 with LDAC 406 providing trim cooling to the cooling liquid coming from LC 404, first cooling liquid circuit 436 and second cooling liquid circuit 438A are coupled to the flow of cooling liquid through cooling liquid supply circuit 422 and cooling liquid return circuit 428. The cooling liquid is cooled to a first temperature by EC 412 of LC 304 and is delivered from outlet 418 of EC 412 to AE 440 of LDAC 406 via cooling liquid supply circuit 422 and first cooling liquid circuit 436. LDAC 406, and, in particular, AE 440 cools the cooling liquid further to the set point temperature required by heat load 402 and cold cooling liquid is delivered from AE 440 to inlet 420 of heat load 402 via cooling liquid supply circuit 422 and first cooling liquid circuit 436. Additionally, in such cases, hot cooling liquid into which heat load 402 has rejected heat is delivered from outlet 424 of heat load 402 to desiccant cooler 444 via cooling liquid return circuit 428 and second cooling liquid circuit 438A. And, the further heated hot cooling liquid is delivered from desiccant cooler 444 to inlet 426 of dry coil 414 via second cooling liquid circuit 438A and cooling liquid return circuit 428.

In both of the foregoing operational examples of conditioning system 400A, the hot return cooling liquid entering dry coil 414 at inlet 426 is sensibly pre-cooled by dry coil 414 using scavenger air and delivered from liquid outlet 430 to liquid inlet 432 of EC 412 via pre-cooling liquid circuit 433. In other words, whether returning to LC 404 from heat load 402 directly or from desiccant cooler 444 of LDAC 406, the hot return cooling liquid is pre-cooled by dry coil 414 using scavenger air exiting EC 412 before the cooling liquid is recycled through EC 412.

Scavenger air plenum 405 of LC 404 includes air inlet 408 and air outlet 410 through which fan 416 can cause a scavenger air stream flow through one or both of EC 412 and dry coil 414, depending upon the operational mode of LC 404. Plenum 405 can also be referred to as a housing, cabinet or structure, and can be configured to house one or more components used to condition air or water. Plenum 405 and the conditioning components it houses can be disposed in various locations relative to heat load 402, for example, outside of an enclosed space having heat load 402 or located external to the devices that produce heat load 402. Additionally, scavenger air channeled through plenum 405 can be from various sources, including, in examples, outside air. More generally, scavenger air is air that is not what may be referred to as process air, which process air is used to directly condition temperature and/or humidity of a heat load, e.g., an enclosed space. In examples, a filter (not shown) can be arranged inside scavenger plenum 405 near air inlet 408. In other examples, a filter (not shown) can be arranged inside scavenger plenum 405 near air outlet 410. And, in other examples, one filter can be arranged inside scavenger plenum 405 near air inlet 408, and another filter can be arranged inside scavenger plenum 405 near air outlet 410.

The scavenger air entering plenum 405 can pass through EC 412. EC 412 can be configured to condition the cooling liquid and/or the scavenger air passing there through using the cooling liquid (may also be referred to in reference to operation of evaporative coolers as an evaporative liquid). EC 412 can use the cooling potential in both the air and the evaporative liquid to reject heat. In an example, as scavenger air flows through EC 412, the evaporative liquid, or both the scavenger air and the evaporative liquid, can be cooled to a temperature approaching the wet bulb (WB) temperature of the air entering plenum 405. Due to the evaporative cooling process in EC 412, a temperature of the cooling liquid at outlet 418 of EC 412 can be less than a temperature of the cooling liquid at inlet 432; and a temperature of the scavenger air exiting EC 412 in scavenger plenum 405 can be less than a temperature of the scavenger air entering EC 412. In some cases, a temperature reduction of the cooling liquid can be significant, whereas in other cases, the temperature reduction can be minimal. Similarly, a temperature reduction of the scavenger air can range between minimal and significant. In some cases, the scavenger air temperature can increase across EC 412. Such temperature reduction of one or both of the cooling liquid and the scavenger air can depend in part on the outdoor air conditions (temperature, humidity), and operation of EC 412 and/or dry coil 414.

EC 412 can be any type of evaporative cooler configured to exchange energy between an air stream and a cooling liquid through evaporation of a portion of the liquid into the air. Evaporative coolers can include direct-contact evaporation devices in which the working air stream and the liquid water (or other liquid) stream that is evaporated into the air to drive heat transfer are in direct contact with one another. In what is sometimes referred to as "open" direct-contact evaporation devices, the liquid water may be sprayed or misted directly into the air stream, or, alternatively the water is sprayed onto a filler material or wetted media across which the air stream flows. As the unsaturated air is directly exposed to the liquid water, the water evaporates into the air, and, in some cases, the water is cooled.

Such direct-contact evaporation devices can also include what is sometimes referred to as a closed circuit device. Unlike the open direct-contact evaporative device, the closed system has two separate liquid circuits. One is an external circuit in which water is recirculated on the outside of the second circuit, which is tube bundles (closed coils) connected to the process for the hot liquid being cooled and returned in a closed circuit. Air is drawn through the recirculating water cascading over the outside of the hot tubes, providing evaporative cooling similar to an open circuit. In operation the heat flows from the internal liquid circuit, through the tube walls of the coils, to the external circuit and then by heating of the air and evaporation of some of the water, to the atmosphere.

These different types of evaporative coolers can also be packaged and implemented in specific types of systems. For example, a cooling tower can include an evaporative cooling device such as those described above. A cooling tower is a device that processes working air and water streams in generally a vertical direction and that is designed to reject waste heat to the atmosphere through the cooling of a water stream to a lower temperature. Cooling towers can transport the air stream through the device either through a natural draft or using fans to induce the draft or exhaust of air into the atmosphere. Cooling towers include or incorporate a direct-contact evaporation device/components, as described above.

Examples of evaporative coolers usable in the conditioning systems of the present application can also include other types of evaporative cooling devices, including liquid-to-air membrane energy exchangers. Unlike direct-contact evaporation devices, a liquid-to-air membrane energy exchanger (LAMEE) separates the air stream and the liquid water stream by a permeable membrane, which allows water to evaporate on the liquid water stream side of the membrane and water vapor molecules to permeate through the membrane into the air stream. The water vapor molecules permeated through the membrane saturate the air stream and the associated energy caused by the evaporation is transferred between the liquid water stream and the air stream by the membrane.

In at least some examples in which EC 412 is a LAMEE, the LAMEE can include a stack of alternating air and liquid channels, through which scavenger air and the cooling liquid flow and in which each air channel is separated from a pair of adjacent liquid channels by permeable membranes. The liquid channels may be formed as polymer liquid panels, each of which direct the cooling liquid through a plurality of liquid flow channels enclosed by permeable membranes affixed to opposing faces of the liquid panel. In examples, such a liquid panel can in include a plurality of liquid inlets and liquid outlets that are connected by a plurality of liquid flow channels. Additionally, in examples, each liquid inlet and each liquid outlet can direct cooling liquid into and out of a plurality of liquid flow channels.

Example LAMEE ECs in accordance with this disclosure can employ permeable membranes to separate the cooling liquid and air flows/streams there through. The permeable membranes of the adjacent liquid panels of the LAMEE can be structured and configured to be permeable to water vapor, but not to other constituents that may be present in the cooling liquid. Thus, generally anything in the cooling liquid in a gas phase can pass through the membranes and generally anything in a liquid or solid phase cannot pass through the membranes. Such membranes can include porous, micro-porous, non-porous, and selectively permeable membranes, as examples. In examples, the membranes of example absorber-evaporator devices in accordance with this disclosure can be a micro-porous structure membrane formed as a thin film of a low surface energy polymer such as PTFE, polypropylene or polyethylene. The hydrophobic membrane resists penetration by the liquid due to surface tension, while freely allowing the transfer of gases, including water vapor, through the membrane pores. In examples, the membranes can be between about 20 to about 100 microns thick with a mean pore size of 0.1-0.2 micron.

Membrane exchangers may have some advantages over other types of evaporative coolers. For example, the LAMEE may eliminate or mitigate maintenance requirements and concerns of conventional cooling towers or other systems including direct-contact evaporation devices, where the water is in direct contact with the air stream that is saturated by the evaporated water. For example, the membrane barriers of the LAMEE inhibit or prohibit the transfer of contaminants and micro-organisms between the air and the liquid stream, as well as inhibiting or prohibiting the transfer of solids between the water and air.

In an example, the cooling (evaporative) liquid in EC 412 can be water or predominantly water. It is recognized that other types of evaporative cooling liquids can be used in combination with water or as an alternative to water in the other conditioning systems described herein, including, for example, liquid desiccants.

Dry coil (or recovery coil) 414 is arranged inside plenum 405 downstream of EC 412. Dry coil 414 can be configured to sensibly cool the cooling liquid flowing through the coil using the scavenger air. In some examples, dry coil 414 sensibly cools the cooling liquid flowing through the coil using the scavenger air exiting EC 412. The scavenger air exiting EC 412 can, in some cases be relatively cool and additional sensible heat from the cooling liquid passing through coil 414 can be rejected into the scavenger air. In some other examples in which EC 412 is bypassed or deactivated, dry coil 414 sensibly cools the cooling liquid flowing through the coil using the scavenger air entering plenum 405 at (or at conditions at) air inlet 408. In the examples of FIGS. 4A and 4B (and some other examples according to this disclosure), dry coil 414 sensibly pre-cools the cooling liquid returned to LC 404 either from heat load 402 or desiccant cooler 444 using the scavenger air exiting EC 412. The pre-cooled cooling liquid is transported from outlet 430 of coil 414 to inlet 432 of EC 412 to be recycled through the evaporative cooler.

In operational examples of conditioning system 400A, reduced-temperature cooling liquid provides cooling to heat load 402. In examples in which head load 402 includes hot air from an enclosed space, the design of conditioning system 400A can eliminate the steps of and components for moving hot supply air from the enclosed space through the conditioning system and then back to the enclosed space. The reduced-temperature cooling liquid can provide cooling to heat load 402 using any known methods to reject heat from air or one or more devices, such methods can include, but are not limited to, liquid immersing technology, cold plate technology, rear door heat exchangers, cooling distribution units (CDU), and cooling coils. In an example, the cooling liquid can directly cool one or more components producing heat load 402. The one or more components can include, but are not limited to, electrical components. In an example in which the heat load 402 comes from an enclosed space, the cooled cooling liquid can pass through one or more cooling coils placed in a path of the supply air in the enclosed space, and the cooling liquid in the cooling coils can sensibly cool the supply air.

Reduced-temperature cooling liquid is described above as being delivered to heat load 402 (an enclosed space or a device or devices) for providing liquid cooling. In other examples, instead of delivering the cooling liquid from system 400A to heat load 402, the reduced temperature cooling liquid can be delivered to a liquid-to-liquid heat exchanger (LLHX) to use the cooling liquid to reduce a temperature of a secondary coolant circulating through the LLHX. The secondary coolant can be configured to provide cooling to the enclosed space or one or more devices, and the coolant can receive the heat rejected from the enclosed space or one or more devices, resulting in a temperature increase of the secondary coolant, which is then recirculated back to the LLHX.

System controller 450 can include hardware, software, and combinations thereof to implement the functions attributed to the controller herein. System controller 450 can be an analog, digital, or combination analog and digital controller including a number of components. As examples, controller 450 can include ICB(s), PCB(s), processor(s), data storage devices, switches, relays, etcetera. Examples of processors can include any one or more of a microprocessor, a controller, a digital signal processor (DSP), an application specific integrated circuit (ASIC), a field-programmable gate array (FPGA), or equivalent discrete or integrated logic circuitry. Storage devices, in some examples, are described as a computer-readable storage medium. In some examples, storage devices include a temporary memory, meaning that a primary purpose of one or more storage devices is not long-term storage. Storage devices are, in some examples, described as a volatile memory, meaning that storage devices do not maintain stored contents when the computer is turned off. Examples of volatile memories include random access memories (RAM), dynamic random access memories (DRAM), static random access memories (SRAM), and other forms of volatile memories known in the art. The data storage devices can be used to store program instructions for execution by processor(s) of controller 450. The storage devices, for example, are used by software, applications, algorithms, as examples, running on and/or executed by controller 450. The storage devices can include short-term and/or long-term memory, and can be volatile and/or non-volatile. Examples of non-volatile storage elements include magnetic hard discs, optical discs, floppy discs, flash memories, or forms of electrically programmable memories (EPROM) or electrically erasable and programmable (EEPROM) memories.

System controller 450 can be configured to communicate with conditioning system 400A and components thereof via various wired or wireless communications technologies and components using various public and/or proprietary standards and/or protocols. For example, a power and/or communications network of some kind may be employed to facilitate communication and control between controller 450 and conditioning system 400A. In one example, system controller 450 can communicate with conditioning system 400A via a private or public local area network (LAN), which can include wired and/or wireless elements functioning in accordance with one or more standards and/or via one or more transport mediums. In one example, controller 450 and system 400A can be configured to use wireless communications according to one of the 802.11 or Bluetooth specification sets, or another standard or proprietary wireless communication protocol. Data transmitted to and from components of system 400A, including controller 450, can be formatted in accordance with a variety of different communications protocols. For example, all or a portion of the communications can be via a packet-based, Internet Protocol (IP) network that communicates data in Transmission Control Protocol/Internet Protocol (TCP/IP) packets, over, for example, Category 5, Ethernet cables.

System controller 450 can include one or more programs, circuits, algorithms or other mechanisms for controlling the operation of conditioning system 400A. For example, system controller 450 can be configured to modulate the speed of the fan 416. Additionally, controller 450 can be configured to control operation of valves, pumps, or other devices that are configured to couple and decouple first cooling liquid circuit 436 to/from cooling liquid supply circuit 422 and/or couple and decouple second cooling liquid circuit 438A to/from cooling liquid return circuit 428.

A system controller is not specifically shown in all of the figures for the various conditioning systems described below. However, it is recognized that the other conditioning systems can include a system controller, which is similarly structured and configured and which operates similar to system controller 450.

As noted, conditioning system 400A can utilize reduced-temperature cooling liquid to provide cooling to heat load 402. In an example, heat load 402 can be a data center or other enclosed space. The reduced-temperature cooling liquid can be transported from conditioning system 400A, which can be disposed outside of the data center, to the data center or other enclosed space. In contrast, for some existing data center (or other enclosed space) air-cooling designs, process air from the data center is delivered to the cooling system which is configured as a larger unit for two air flow paths - the process air and the scavenger air. Thus, in such cases, more energy is used to move the process air from the data center to the cooling system and then condition the process air. In the systems described herein, less energy by comparison can be used to deliver the reduced-temperature cooling liquid from the conditioning system to the data center. Moreover, in examples in which the cooling liquid is water, water has a higher thermal capacity than air; thus a lower flow rate of water can be used, compared to air, to reject a certain amount of heat directly from one or more electrical components in the data center (or other components needing cooling) or from the air in the data center.

Similar to that previously described with respect to the LDAC units 100 & 306, the LDAC unit 406 includes a regenerator 442 that is structured and configured to receive dilute desiccant from the AE 440, draw water out of the desiccant, and channel the concentrated (regenerated/restored) desiccant and recovered water out of the device. For example, regenerator 442 can be configured to receive the liquid desiccant at a regenerator inlet and separate the water and desiccant into a concentrated desiccant stream, which exits regenerator 442 at a regenerator outlet, and a water stream, which exits the regenerator 442 at recovered water outlet 446. The water recovered by regenerator 442 can be used as a pure water supply by other components of the conditioning system such as to reduce overall water consumption of the system, and/or stored in a tank or other reservoir. For example, as depicted in FIG. 4A & FIG. 4B, recovered water exiting the recovered water outlet 446 can be directed to return to the liquid return circuit 428 as makeup water. In another example, recovered water exiting the recovered water outlet 446 can be directed to a reservoir to be, e.g., conditioned or stored before being injected back into conditioning system 400 as makeup water. Here, the water recovered by regenerator 442 is used to mitigate or eliminate net water loss from the first liquid cooling circuit 436 resulting from, e.g., evaporative cooling by the AE 440.

The concept of providing cooling or conditioning to a heat load as described in this disclosure can refer to using a cooling liquid that is cooled by a conditioning system, including at least an LDAC in accordance with this disclosure to provide cooling to air in an enclosed space or to provide liquid cooling to one or more devices or components (within an enclosed space or open to the atmosphere). This concept can also refer to using the reduced-temperature cooling liquid to reduce a temperature of a secondary coolant in, e.g. an LLHX, the secondary coolant being used to receive heat rejected from the enclosed space or one or more devices. The devices or components in the space (e.g., data center) can be directly cooled with the reduced-temperature cooling liquid, the air around the components can be cooled (if contained within an enclosed space), or a combination can be used. Although the present application focuses on a data center as an example of an enclosed space with a heat load, the systems and methods disclosed herein for cooling can be used in other examples of enclosed spaces, including for example, a telecommunication room, industrial applications and commercial and residential spaces.

FIG. 4B schematically depicts example conditioning system 400B structured, arranged, and configured to deliver cooled liquid to heat load 402. Example conditioning system 400B of FIG. 4B is the same as example conditioning system 400A of FIG. 4A, with the notable exception of second cooling liquid circuit 438B. In the example of FIG. 4B, second cooling liquid circuit 438B, which transports the cooling liquid through desiccant cooler 444, is coupled on the inlet side of cooler 444 to cooling liquid supply circuit 422 and on the outlet side of cooler 444 to cooling liquid return circuit 428.

Referring to FIG. 4B, conditioning system 400B includes liquid cooler (LC) 404 fluidically connected to LDAC 406. In this example, LC 404 includes scavenger air plenum 405 having air inlet 408 and air outlet 410, evaporative cooler (EC) 412, dry coil 414, and fan 416. Dry coil 414 may also be referred to as a recovery coil and is a type of liquid-to-air heat exchanger. In other examples according to this disclosure, another type of LAHX may be employed in lieu of a dry coil.

In general, LC 404 is configured to cool a cooling liquid and deliver the cooling liquid to heat load 402, which can be an enclosed space such as a data center with heat generating electronic devices. The liquid supplied by LC 404 and, more generally, system 400B can be used by various air or liquid cooling systems to modulate conditions of the heat load. In some ambient conditions, LC 404 may not be capable of cooling the liquid sufficiently to carry the load of heat load 402. As such, LC 404 is fluidically coupled to LDAC 406, which can provide trim cooling to the cooling liquid delivered to heat load 402.

LC 404, LDAC 406, and heat load 402 include and/or are connected by a number of liquid circuits. Liquid outlet 418 of EC 412 of LC 404 is connected to liquid inlet 420 of heat load 402 by cooling liquid supply circuit 422. Liquid outlet 424 of heat load 402 is connected to liquid inlet 426 of dry coil 414 of LC 304 by cooling liquid return circuit 428. And, liquid outlet 430 of dry coil 414 is connected to liquid inlet 432 of EC 412 by pre-cooling liquid circuit 433. LDAC 406 includes liquid desiccant circuit 434 by which it recirculates liquid desiccant through the system, first cooling liquid circuit 436 by which it selectively circulates cooling liquid from LC 404 to heat load 402, and second cooling liquid circuit 438B by which it selectively circulates cooling liquid from LC 404, through desiccant cooler 444 and back to LC 404. The routing of cooling liquid from LC 404 to heat load 402, from LC 404 to LDAC 406 to heat load 402, from heat load 402 to LC 404, and from heat load 402 to LDAC 406 to LC 404 can be implemented using a variety of types and number of devices or other techniques, including various number and types of valves, tanks or other reservoirs, and pumps.

LDAC 406 includes absorber-evaporator (AE) 440, regenerator 442, and desiccant cooler 444. LDAC 406 can be substantially similar to LDAC unit 100 of the example of FIG. 1. The components, structures, configuration, functions, etc. of LDAC 406 can therefore be the same as or substantially similar to that described in detail above with reference to LDAC unit 100. Additionally, AE 440 can be substantially similar to AE 200 of the example of FIG. 2. The components, structures, configuration, functions, etc. of AE 440 can therefore be the same as or substantially similar to that described in detail above with reference to AE 200.

In examples, conditioning system 400B can cool the cooling liquid delivered to heat load 402 employing LC 404 without trim cooling from LDAC 406. Additionally, conditioning system 400B can cool the cooling liquid delivered to heat load 402 employing LC 404 with LDAC 406 providing trim cooling to the cooling liquid coming from LC 404 and delivered from LDAC 406 to heat load 402.

In examples in which conditioning system 400B cools the cooling liquid delivered to heat load 402 employing LC 404 without trim cooling from LDAC 406, the cooling liquid is cooled to a set point temperature required by heat load 402 and cold cooling liquid is delivered from outlet 418 of LC 404 to inlet 420 of heat load 402 via cooling liquid supply circuit 422. Additionally, in such cases, hot cooling liquid into which heat load 402 has rejected heat is returned to inlet 426 of dry coil 414 from outlet 424 of heat load 402 via cooling liquid return circuit 428. Finally, in such cases, first cooling liquid circuit 436 and second cooling liquid circuit 438B are decoupled from the flow of cooling liquid through cooling liquid supply circuit 422 and cooling liquid return circuit 428.

In examples in which conditioning system 400B cools the cooling liquid delivered to heat load 402 employing LC 404 with LDAC 406 providing trim cooling to the cooling liquid coming from LC 404, first cooling liquid circuit 436 and second cooling liquid circuit 438B are coupled to the flow of cooling liquid through cooling liquid supply circuit 422 and cooling liquid return circuit 428. The cooling liquid is cooled to a first temperature by EC 412 of LC 304 and is delivered from outlet 418 of EC 412 to AE 440 of LDAC 406 via cooling liquid supply circuit 422 and first cooling liquid circuit 436. Additionally, in this example compared to the example of FIG. 4A, the cooling liquid at the first temperature from EC 412 of LC 304 is delivered from outlet 418 of EC 412 to desiccant cooler 444 of LDAC 406 via cooling liquid supply circuit 422 and second cooling liquid circuit 438B. LDAC 406, and, in particular, AE 440 cools the cooling liquid further to the set point temperature required by heat load 402 and cold cooling liquid is delivered from AE 440 to inlet 420 of heat load 402 via cooling liquid supply circuit 422 and first cooling liquid circuit 436. Additionally, in such cases, hot cooling liquid into which heat load 402 has rejected heat is delivered from outlet 424 of heat load 402 to inlet 426 of dry coil 414 via cooling liquid return circuit 428, and hot cooling liquid into which liquid desiccant flowing through desiccant cooler 444 has rejected heat is delivered from desiccant cooler to inlet 426 of dry coil 414 via cooling liquid return circuit 428 and second cooling liquid circuit 438B.

In both of the foregoing operational examples of conditioning system 400B, the hot return cooling liquid entering dry coil 414 at inlet 426 is sensibly pre-cooled by dry coil 414 using scavenger air and delivered from liquid outlet 430 to liquid inlet 432 of EC 412 via pre-cooling liquid circuit 433. In other words, whether returning to LC 404 from heat load 402 directly or from desiccant cooler 444 of LDAC 406, the hot return cooling liquid is pre-cooled by dry coil 414 using scavenger air exiting EC 412 before the cooling liquid is recycled through EC 412.

The examples of FIGS. 4A and 4B may each have advantages and benefits depending upon the intended application of the system and the environment in which it is employed. In FIG. 4A, for example, the second cooling liquid circuit 438A of desiccant cooler 444 is supplied by warm return water from the cooling liquid return circuit 428. This means that desiccant leaving temperatures from the cooler 444 will be higher, and the LDAC 406 will need to run with higher desiccant concentrations which degrades the performance of the regenerator 442. But the full cold supply flow rate from the LC 404 is available for process water cooling. Alternatively, the second cooling liquid circuit 438B of Fig 4B diverts some cool water from the hybrid cooler to lower the desiccant temperatures and improve regenerator 442 performance (e.g., improve regenerator COP, allow lower grade heat sources, etc.). In this example, desiccant leaving temperatures from the cooler will be lower, and the LDAC 406 can run with lower desiccant concentrations, but some of the cold supply liquid flow rate is made unavailable for process cooling to the heat load 402.

In another example, a conditioning system in accordance with this disclosure includes both the second cooling circuit 438A as depicted in FIG. 4A and in the second cooling circuit 438B as depicted in FIG. 4B and is capable of switching between these two different flow paths for the cooling liquid entering desiccant cooler 444. Here, cooling liquid can be selectively supplied to the desiccant cooler 444 from either of circuit 438A or circuit 438B in response to, e.g., varying outdoor air conditions or heat load cooling requirements. For example, such an example conditioning system can include a second modulating valve (or other device or system capable of directing the flow of liquid along multiple paths, and such device or system can be employed alone or in combination with other components such as pumps, tanks or other reservoirs, manifolds, etc.) to distribute a portion of cooling liquid from either or both of circuits 438A and 438B to supply to the desiccant cooler 444. The second modulating valve can interchangeably supply cooling liquid from one of the circuit 438A or circuit 438B based on the needs of the conditioning system or the heat load 402. Alternatively, the second modulating valve can variably supply a portion cooling liquid from either or both circuit 438A and circuit 438B. Also, the conditioning system can include a tank or reservoir for mixing cooling liquid from either or both of circuits 438A and 438B for subsequent supply to the desiccant cooler 444. Fluid circuits employed in examples according to this disclosure, including fluid circuits 438A and 438B can include a number of different interconnected conduits or fluid flow pathways, as well as other cooling liquid related components, including, for example, valves, pumps, tanks or other storage vessels, etc.

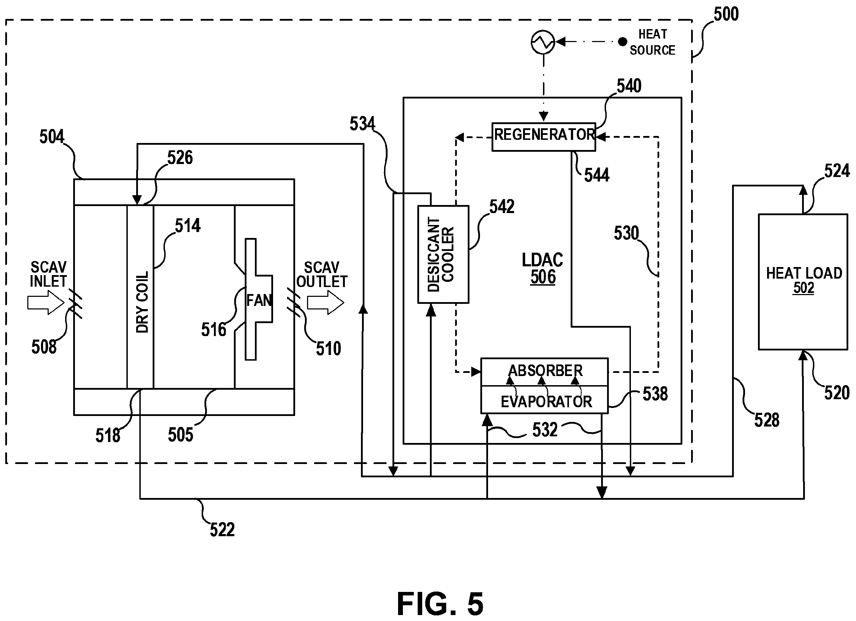

FIG. 5 schematically depicts another example conditioning system 500 in accordance with this disclosure, which is structured, arranged, and configured to deliver cooled liquid to heat load 502. Conditioning system 500 includes liquid cooler (LC) 504 fluidically connected to LDAC 506. In this example, LC 504 includes scavenger air plenum 505 having air inlet 508 and air outlet 510, dry coil 514, and fan 516. Dry coil 514 is a type of liquid-to-air heat exchanger. In other examples according to this disclosure, another type of LAHX may be employed in lieu of a dry coil.

In general, LC 504, and, in particular in this example, dry coil 514 is configured to cool a cooling liquid and deliver the cooling liquid to heat load 502, which can be an enclosed space such as a data center with heat generating electronic devices. The liquid supplied by dry coil 514 and, more generally, system 500 can be used by various air or liquid cooling systems to modulate conditions of the heat load. In some ambient conditions, dry coil 514 may not be capable of cooling the liquid sufficiently to carry the load of heat load 502. As such, dry coil 514 is fluidically coupled to LDAC 506, which can provide trim cooling to the cooling liquid delivered to heat load 502.

Coil 514, LDAC 506, and heat load 502 include and/or are connected by a number of liquid circuits. Liquid outlet 518 of dry coil 514 is connected to liquid inlet 520 of heat load 502 by cooling liquid supply circuit 522. Liquid outlet 524 of heat load 502 is connected to liquid inlet 526 of dry coil 514 by cooling liquid return circuit 528. LDAC 506 includes liquid desiccant circuit 530 by which it recirculates liquid desiccant through the system, first cooling liquid circuit 532 by which it selectively circulates cooling liquid from dry coil 514 to heat load 502, and second cooling liquid circuit 534 by which it selectively circulates cooling liquid from heat load 502 back to dry coil 514. The routing of cooling liquid from dry coil 514 to heat load 502, from dry coil 514 to LDAC 506 to heat load 502, from heat load 502 to dry coil 514, and from heat load 502 to LDAC 506 to dry coil 514 can be implemented using a variety of types and number of devices or other techniques, including various number and types of valves, tanks or other reservoirs, and pumps.

LDAC 506 includes absorber-evaporator (AE) 538, regenerator 540, and desiccant cooler 542. LDAC 506 can be substantially similar to LDAC unit 100 of the example of FIG. 1. The components, structures, configuration, functions, etc. of LDAC 506 can therefore be the same as or substantially similar to that described in detail above with reference to LDAC unit 100. Additionally, AE 538 can be substantially similar to AE 200 of the example of FIG. 2. The components, structures, configuration, functions, etc. of AE 538 can therefore be the same as or substantially similar to that described in detail above with reference to AE 200.

In examples, conditioning system 500 can cool the cooling liquid delivered to heat load 502 employing dry coil 514 without trim cooling from LDAC 506. Additionally, conditioning system 500 can cool the cooling liquid delivered to heat load 502 employing dry coil 514 with LDAC 506 providing trim cooling to the cooling liquid coming from dry coil 514 and delivered from LDAC 506 to heat load 502.

In examples in which conditioning system 500 cools the cooling liquid delivered to heat load 502 employing dry coil 514 without trim cooling from LDAC 506, the cooling liquid is cooled by dry coil 514 using scavenger air to a set point temperature required by heat load 502 and cold cooling liquid is delivered from outlet 518 of dry coil 514 to inlet 520 of heat load 502 via cooling liquid supply circuit 522. Additionally, in such cases, hot cooling liquid into which heat load 502 has rejected heat is returned to inlet 526 of dry coil 514 from outlet 524 of heat load 502 via cooling liquid return circuit 528. Finally, in such cases, first cooling liquid circuit 532 and second cooling liquid circuit 534 are decoupled from the flow of cooling liquid through cooling liquid supply circuit 522 and cooling liquid return circuit 528.

In examples in which conditioning system 500 cools the cooling liquid delivered to heat load 502 employing dry coil 514 with LDAC 506 providing trim cooling to the cooling liquid coming from dry coil 514, first cooling liquid circuit 532 and second cooling liquid circuit 534 are coupled to the flow of cooling liquid through cooling liquid supply circuit 522 and cooling liquid return circuit 528. The cooling liquid is cooled to a first temperature by dry coil 514 and is delivered from outlet 518 of dry coil 514 to AE 538 of LDAC 506 via cooling liquid supply circuit 522 and first cooling liquid circuit 532. LDAC 506, and, in particular, AE 538 cools the cooling liquid further to the set point temperature required by heat load 502 and cold cooling liquid is delivered from AE 538 to inlet 520 of heat load 502 via cooling liquid supply circuit 522 and first cooling liquid circuit 532. Additionally, in such cases, hot cooling liquid into which heat load 502 has rejected heat is delivered from outlet 524 of heat load 502 to desiccant cooler 542 via cooling liquid return circuit 528 and second cooling liquid circuit 534. And, the further heated hot cooling liquid is delivered from desiccant cooler 542 to inlet 526 of dry coil 514 via second cooling liquid circuit 534 and cooling liquid return circuit 528.

Scavenger air plenum 505 of LC 504 includes air inlet 508 and air outlet 510 through which fan 516 can cause a scavenger air stream to flow through dry coil 514. Plenum 505 can also be referred to as a housing, cabinet or structure, and can be configured to house one or more components used to condition air and/or a cooling liquid. Plenum 505 and the conditioning components it houses can be disposed in various locations relative to heat load 502, for example, outside of an enclosed space having heat load 502 or located external to the devices that produce heat load 502. Additionally, scavenger air channeled through plenum 505 can be from various sources, including, in examples, outside air. More generally, scavenger air is air that is not what may be referred to as process air, which process air is used to directly condition temperature and/or humidity of a heat load, e.g., an enclosed space. In examples, a filter (not shown) can be arranged inside scavenger plenum 505 near air inlet 508.

The scavenger air entering plenum 505 can pass through dry coil 514. Dry coil 514 can be configured to sensibly cool the cooling liquid flowing through the coil using the scavenger air. Dry coil 514 is a type of liquid-to-air heat exchanger. In other examples according to this disclosure, another type of LAHX may be employed in lieu of a dry coil. In one example, the LAHX can be a cooling coil. Cooling coils are commonly formed of coiled copper tubes embedded in a matrix of fins. In another example, the LAHX can be a polymer fluid cooler (PFC). Such a PFC can be, for example, a PolyCoil polymeric heat exchanger from Cesaroni Technology Inc. of Gormley, Ontario in Canada. Other example LAHXs that can be used include micro-channel heat exchangers or air plate exchangers.

In operational examples of conditioning system 500, reduced-temperature cooling liquid provides cooling to heat load 502. In examples in which head load 502 includes hot air from an enclosed space, the design of conditioning system 500 can eliminate the steps of and components for moving hot supply air from the enclosed space through the conditioning system and then back to the enclosed space. The reduced-temperature cooling liquid can provide cooling to heat load 502 using any known methods to reject heat from air or one or more devices, such methods can include, but are not limited to, liquid immersing technology, cold plate technology, rear door heat exchangers, cooling distribution units (CDU), and cooling coils. In an example, the cooling liquid can directly cool one or more components producing heat load 502. The one or more components can include, but are not limited to, electrical components. In an example in which the heat load 502 comes from an enclosed space, the cooled cooling liquid can pass through one or more cooling coils placed in a path of the supply air in the enclosed space, and the cooling liquid in the cooling coils can sensibly cool the supply air.

Reduced-temperature cooling liquid is described above as being delivered to heat load 502 (an enclosed space or a device or devices) for providing liquid cooling. In other examples, instead of delivering the cooling liquid from system 500 to heat load 502, the reduced temperature cooling liquid can be delivered to an LLHX to use the cooling liquid to reduce a temperature of a secondary coolant circulating through the LLHX. The secondary coolant can be configured to provide cooling to the enclosed space or one or more devices, (or other heat loads) and the coolant can receive the heat rejected from the enclosed space or one or more devices, resulting in a temperature increase of the secondary coolant, which is then recirculated back to the LLHX.

Similar to that previously described with respect to the LDAC units 100, 306, & 406, the LDAC unit 506 includes a regenerator 540 that is structured and configured to receive dilute desiccant from the AE 538, draw water out of the desiccant, and channel the concentrated (regenerated/restored) desiccant and recovered water out of the device. For example, regenerator 540 can be configured to receive the liquid desiccant at a regenerator inlet and separate the water and desiccant into a concentrated desiccant stream, which exits regenerator 540 at a regenerator outlet, and a water stream, which exits the regenerator 540 at recovered water outlet 544. The water recovered by regenerator 540 can be used as a pure water supply by other components of the conditioning system such as to reduce overall water consumption of the system, and/or stored in a tank or other reservoir. For example, as depicted in FIG. 5, recovered water exiting the recovered water outlet 544 can be directed to return to the cooling liquid return circuit 528 as makeup water. In another example, recovered water exiting the recovered water outlet 544 can be directed to a reservoir to be, e.g., conditioned or stored before being injected back into conditioning system 500 as makeup water. Here, the water recovered by regenerator 540 is used to mitigate or eliminate net water loss from the first liquid cooling circuit 532 resulting from, e.g., evaporative cooling by the AE 538.

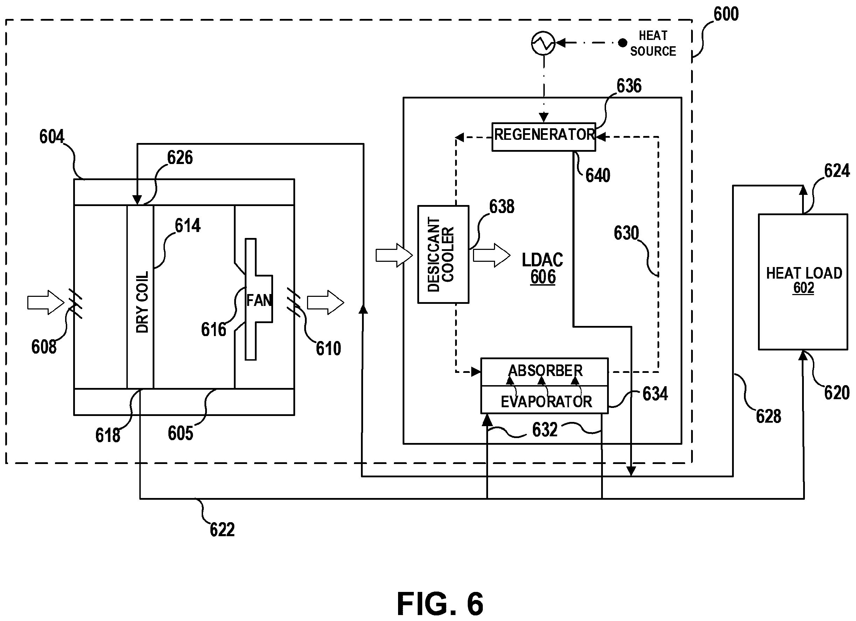

FIG. 6 schematically depicts another example conditioning system 600 in accordance with this disclosure, which is structured, arranged, and configured to deliver cooled liquid to heat load 602. Conditioning system 600 includes liquid cooler (LC) 604 fluidically connected to LDAC 606. In this example, LC 604 includes scavenger air plenum 605 having air inlet 608 and air outlet 610, dry coil 614, and fan 616. Dry coil 614 is a type of liquid-to-air heat exchanger. In other examples according to this disclosure, another type of LAHX may be employed in lieu of a dry coil.

In general, LC 604, and, in particular in this example, dry coil 614 is configured to cool a cooling liquid and deliver the cooling liquid to heat load 502, which can be an enclosed space such as a data center with heat generating electronic devices. The liquid supplied by dry coil 614 and, more generally, system 600 can be used by various air or liquid cooling systems to modulate conditions of the heat load. In some ambient conditions, dry coil 614 may not be capable of cooling the liquid sufficiently to carry the load of heat load 602. As such, dry coil 614 is fluidically coupled to LDAC 506, which can provide trim cooling to the cooling liquid delivered to heat load 502.

Coil 614, LDAC 606, and heat load 602 include and/or are connected by a number of liquid circuits. Liquid outlet 618 of dry coil 614 is connected to liquid inlet 620 of heat load 602 by cooling liquid supply circuit 622. Liquid outlet 624 of heat load 602 is connected to liquid inlet 626 of dry coil 614 by cooling liquid return circuit 628. LDAC 606 includes liquid desiccant circuit 630 by which it recirculates liquid desiccant through the system and cooling liquid circuit 632 by which it selectively circulates cooling liquid from dry coil 614 to heat load 602. The routing of cooling liquid from dry coil 614 to heat load 602, from dry coil 614 to LDAC 606 to heat load 602, and from heat load 602 to dry coil 614 can be implemented using a variety of types and number of devices or other techniques, including various number and types of valves, tanks or other reservoirs, and pumps.

LDAC 606 includes absorber-evaporator (AE) 634, regenerator 636, and desiccant cooler 638. LDAC 606 can be substantially similar to LDAC unit 100 of the example of FIG. 1. The components, structures, configuration, functions, etc. of LDAC 606 can therefore be the same as or substantially similar to that described in detail above with reference to LDAC unit 100. However, example LDAC 606 includes a liquid-to-air desiccant cooler 638 (versus the liquid-to-liquid cooler depicted in FIG. 1). In this example, a scavenger air stream (may be referred to as or considered a second scavenger air stream relative to the first scavenger air stream flowing through LC 604) is channeled through desiccant cooler 638 and sensibly cools the liquid desiccant. Although not shown in detail, desiccant cooler 638 may be arranged in a scavenger plenum or other housing, cavity, etcetera through which the air is directed to sensibly cool the desiccant recirculating through LDAC 606.

AE 634 of LDAC 606 can be substantially similar to AE 200 of the example of FIG. 2. The components, structures, configuration, functions, etc. of AE 634 can therefore be the same as or substantially similar to that described in detail above with reference to AE 200.

In examples, conditioning system 600 can cool the cooling liquid delivered to heat load 602 employing dry coil 614 without trim cooling from LDAC 606. Additionally, conditioning system 600 can cool the cooling liquid delivered to heat load 602 employing dry coil 614 with LDAC 606 providing trim cooling to the cooling liquid coming from dry coil 614 and delivered from LDAC 606 to heat load 602.

In examples in which conditioning system 600 cools the cooling liquid delivered to heat load 602 employing dry coil 614 without trim cooling from LDAC 606, the cooling liquid is cooled by dry coil 614 using scavenger air to a set point temperature required by heat load 602 and cold cooling liquid is delivered from outlet 618 of dry coil 614 to inlet 620 of heat load 602 via cooling liquid supply circuit 622. Additionally, in such cases, hot cooling liquid into which heat load 602 has rejected heat is returned to inlet 626 of dry coil 614 from outlet 624 of heat load 602 via cooling liquid return circuit 628. Finally, in such cases, first cooling liquid circuit 632 is decoupled from the flow of cooling liquid through cooling liquid supply circuit 622.

In examples in which conditioning system 600 cools the cooling liquid delivered to heat load 602 employing dry coil 614 with LDAC 606 providing trim cooling to the cooling liquid coming from dry coil 614, first cooling liquid circuit 632 is coupled to the flow of cooling liquid through cooling liquid supply circuit 622. The cooling liquid is cooled to a first temperature by dry coil 614 and is delivered from outlet 618 of dry coil 614 to AE 634 of LDAC 606 via cooling liquid supply circuit 622 and first cooling liquid circuit 632. LDAC 606, and, in particular, AE 634 cools the cooling liquid further to the set point temperature required by heat load 602 and cold cooling liquid is delivered from AE 634 to inlet 620 of heat load 602 via cooling liquid supply circuit 622 and first cooling liquid circuit 632. Additionally, in such cases, hot cooling liquid into which heat load 602 has rejected heat is delivered from outlet 624 of heat load 602 to inlet 626 of dry coil 614 via cooling liquid return circuit 628.

Scavenger air plenum 605 of LC 604 includes air inlet 608 and air outlet 610 through which fan 616 can cause a scavenger air stream to flow through dry coil 614. Plenum 605 can also be referred to as a housing, cabinet or structure, and can be configured to house one or more components used to condition air and/or a cooling liquid. Plenum 605 and the conditioning components it houses can be disposed in various locations relative to heat load 602. Additionally, scavenger air channeled through plenum 605 can be from various sources, including, in examples, outside air. In examples, one or more filters (not shown) can be arranged inside scavenger plenum 605 at one or more locations at and/or between inlet 608 and outlet 610.

The scavenger air entering plenum 605 can pass through dry coil 614. Dry coil 614 can be configured to sensibly cool the cooling liquid flowing through the coil using the scavenger air.

In operational examples of conditioning system 600, reduced-temperature cooling liquid provides cooling to heat load 602. In examples in which head load 602 includes hot air from an enclosed space, the design of conditioning system 600 can eliminate the steps of and components for moving hot supply air from the enclosed space through the conditioning system and then back to the enclosed space. The reduced-temperature cooling liquid can provide cooling to heat load 602 using any known methods to reject heat from air or one or more devices, such methods can include, but are not limited to, liquid immersing technology, cold plate technology, rear door heat exchangers, cooling distribution units (CDU), and cooling coils. In an example, the cooling liquid can directly cool one or more components producing heat load 602. The one or more components can include, but are not limited to, electrical components. In an example in which the heat load 602 comes from an enclosed space, the cooled cooling liquid can pass through one or more cooling coils placed in a path of the supply air in the enclosed space, and the cooling liquid in the cooling coils can sensibly cool the supply air.

Reduced-temperature cooling liquid is described above as being delivered to heat load 602 (an enclosed space or a device or devices) for providing liquid cooling. In other examples, instead of delivering the cooling liquid from system 600 to heat load 602, the reduced temperature cooling liquid can be delivered to an LLHX to use the cooling liquid to reduce a temperature of a secondary coolant circulating through the LLHX. The secondary coolant can be configured to provide cooling to the enclosed space or one or more devices, (or other heat loads) and the coolant can receive the heat rejected from the enclosed space or one or more devices, resulting in a temperature increase of the secondary coolant, which is then recirculated back to the LLHX.

Similar to that previously described with respect to the LDAC units 100, 306, 406, & 506, the LDAC unit 606 includes a regenerator 636 that is structured and configured to receive dilute desiccant from the AE 634, draw water out of the desiccant, and channel the concentrated (regenerated/restored) desiccant and recovered water out of the device. For example, regenerator 636 can be configured to receive the liquid desiccant at a regenerator inlet and separate the water and desiccant into a concentrated desiccant stream, which exits regenerator 636 at a regenerator outlet, and a water stream, which exits the regenerator 636 at recovered water outlet 640. The water recovered by regenerator 636 can be used as a pure water supply by other components of the conditioning system such as to reduce overall water consumption of the system, and/or stored in a tank or other reservoir. For example, as depicted in FIG. 6, recovered water exiting the recovered water outlet 640 can be directed to return to the cooling liquid return circuit 628 as makeup water. In another example, recovered water exiting the recovered water outlet 640 can be directed to a reservoir to be, e.g., conditioned or stored before being injected back into conditioning system 600 as makeup water. Here, the water recovered by regenerator 636 is used to mitigate or eliminate net water loss from the first liquid cooling circuit 632 resulting from, e.g., evaporative cooling by the AE 634.

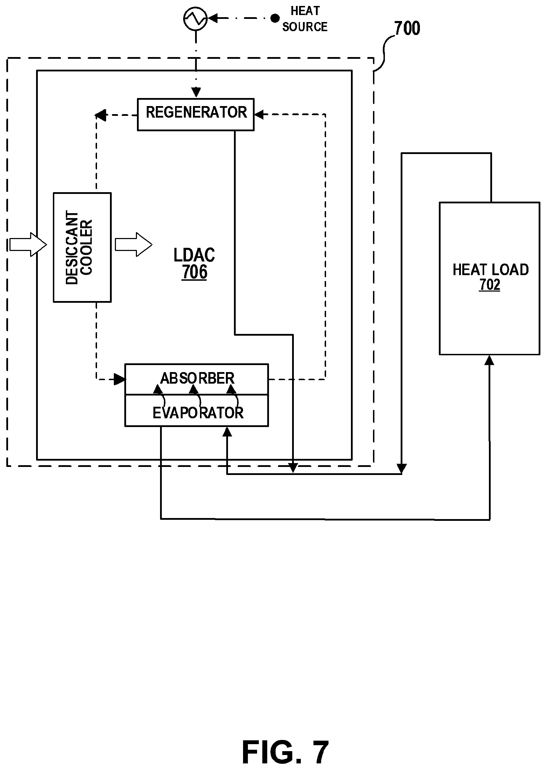

In another example according to this disclosure, LC 604 of conditioning system 600 could be deactivated or eliminated from the system completely such that LDAC 606 or another LDAC in accordance with this disclosure is employed to provide primary cooling (versus supplemental/trim) of the cooling liquid delivered to heat load 602. An example of such a system 700 is schematically depicted in FIG. 7.

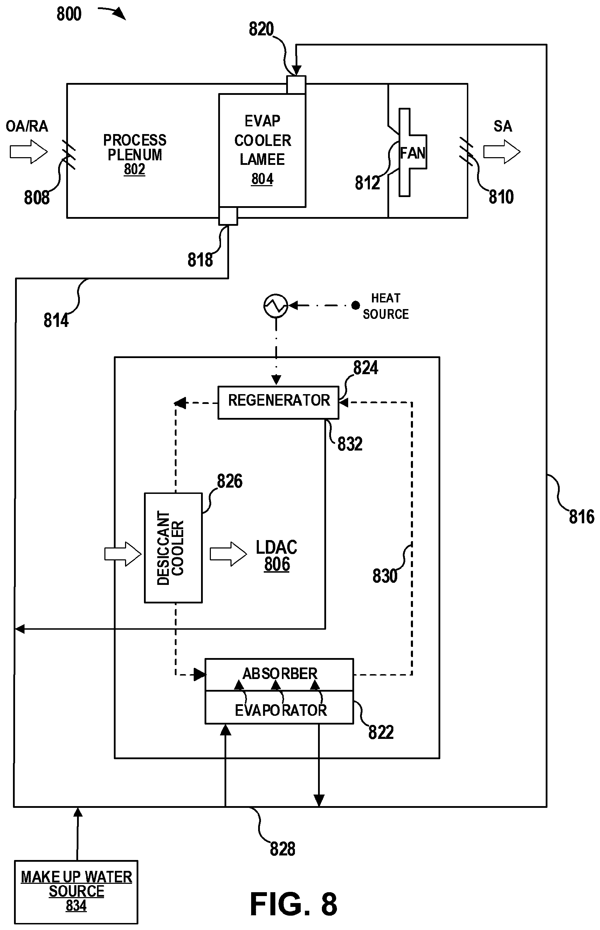

FIG. 8 schematically depicts example conditioning system 800 in accordance with examples of this disclosure. Conditioning system 800 is an air conditioning system in which outdoor and/or return air (OA/RA) from an enclosed space is channeled through process plenum 802, conditioned and supplied to the space as conditioned supply air (SA). For example, conditioning system can be configured to cool supply air to a predetermined set point temperature and deliver the cooled supply air to the enclosed space.

Conditioning system 800 includes evaporative cooler (EC) 804. EC 804 can be a variety of different types of evaporative cooling devices, including a LAMEE. In this system configuration, EC 804 is a direct evaporative cooler, which functions to directly modulate the conditions of the enclosed space using the process supply air by evaporatively cooling the air with a cooling liquid circulating through EC 804. It is possible for some evaporative coolers to be implemented as the primary conditioning component operating adiabatically in such direct evaporative cooling applications. However, due to the manner in which evaporative coolers condition the supply air, e.g., through evaporation sufficient to cool the air to the set point temperature, in hotter and more humid ambient conditions, operating the evaporative cooler adiabatically may deliver oversaturated (relative humidity above acceptable levels) supply air to the enclosed space.

Example conditioning system 800 therefore employs EC 804 in a direct evaporative cooling system configuration that includes LDAC 806 in accordance with examples of this disclosure to provide supplemental (trim) cooling to the cooling liquid flowing through the evaporative cooler. With the added liquid cooling supplied by LDAC 806, EC 804 can be operated in an adiabatic-like mode in peak conditions without oversaturating the supply air delivered to the enclosed space.

In FIG. 8, conditioning system 800 includes process plenum 802 with air inlet 808 and air outlet 810, EC 804, LDAC 806, fan 812, cooling liquid supply circuit 814, and cooling liquid return circuit 816. Process air plenum 802 of conditioning system 800 includes air inlet 808 and air outlet 810 through which fan 812 can cause a process air (e.g., OA or RA) stream to flow through EC 802. In examples, one or more filters (not shown) can be arranged inside process plenum 802 at one or more locations at and/or between inlet 808 and outlet 810.

The process air entering plenum 802 can pass through EC 804. EC 804 can be configured to condition the cooling liquid and/or the process air passing there through using the cooling liquid (may also be referred to in reference to operation of evaporative coolers as an evaporative liquid). EC 804 can use the cooling potential in both the air and the evaporative liquid to reject heat. In an example, as process air flows through EC 804, the cooling liquid, or both the process air and the cooling liquid, can be cooled to a temperature approaching the wet bulb (WB) temperature of the air entering plenum 802. In this system configuration, due to the evaporative cooling process in EC 804, a temperature of the process air exiting EC 804 and delivered as supply air via outlet 810 can be less than a temperature of the process air entering plenum 802 via inlet 808. In examples, a temperature of the cooling liquid at outlet 818 of EC 804 is greater than a temperature of the cooling liquid at inlet 820. In some cases, a temperature reduction of the process air can be significant, whereas in other cases, the temperature reduction can be minimal. Additionally, a temperature increase of the cooling liquid can range from approximately zero to minimal or significant.

EC 804 can be any type of evaporative cooler configured to exchange energy between an air stream and a cooling liquid through evaporation of a portion of the liquid into the air. Evaporative coolers can include direct-contact evaporation devices in which the working air stream and the liquid water (or other liquid) stream that is evaporated into the air to drive heat transfer are in direct contact with one another. In what is sometimes referred to as "open" direct-contact evaporation devices, the liquid water may be sprayed or misted directly into the air stream, or, alternatively the water is sprayed onto a filler material or wetted media across which the air stream flows. As the unsaturated air is directly exposed to the liquid water, the water evaporates into the air, and, in some cases, the water is cooled.

Such direct-contact evaporation devices can also include what is sometimes referred to as a closed circuit device. Unlike the open direct-contact evaporative device, the closed system has two separate liquid circuits. One is an external circuit in which water is recirculated on the outside of the second circuit, which is tube bundles (closed coils) connected to the process for the hot liquid being cooled and returned in a closed circuit. Air is drawn through the recirculating water cascading over the outside of the hot tubes, providing evaporative cooling similar to an open circuit. In operation the heat flows from the internal liquid circuit, through the tube walls of the coils, to the external circuit and then by heating of the air and evaporation of some of the water, to the atmosphere.

These different types of evaporative coolers can also be packaged and implemented in specific types of systems. For example, a cooling tower can include an evaporative cooling device such as those described above. A cooling tower is a device that processes working air and water streams in generally a vertical direction and that is designed to reject waste heat to the atmosphere through the cooling of a water stream to a lower temperature. Cooling towers can transport the air stream through the device either through a natural draft or using fans to induce the draft or exhaust of air into the atmosphere. Cooling towers include or incorporate a direct-contact evaporation device/components, as described above.

Examples of evaporative coolers usable in the conditioning systems of the present application can also include other types of evaporative cooling devices, including liquid-to-air membrane energy exchangers. Unlike direct-contact evaporation devices, a liquid-to-air membrane energy exchanger (LAMEE) separates the air stream and the liquid water stream by a permeable membrane, which allows water to evaporate on the liquid water stream side of the membrane and water vapor molecules to permeate through the membrane into the air stream. The water vapor molecules permeated through the membrane saturate the air stream and the associated energy caused by the evaporation is transferred between the liquid water stream and the air stream by the membrane.

In at least some examples in which EC 804 is a LAMEE, the LAMEE can include a stack of alternating air and liquid channels, through which scavenger air and the cooling liquid flow and in which each air channel is separated from a pair of adjacent liquid channels by permeable membranes. The liquid channels may be formed as polymer liquid panels, each of which direct the cooling liquid through a plurality of liquid flow channels enclosed by permeable membranes affixed to opposing faces of the liquid panel. In examples, such a liquid panel can in include a plurality of liquid inlets and liquid outlets that are connected by a plurality of liquid flow channels. Additionally, in examples, each liquid inlet and each liquid outlet can direct cooling liquid into and out of a plurality of liquid flow channels.

Example LAMEE ECs in accordance with this disclosure can employ permeable membranes to separate the cooling liquid and air flows/streams there through. The permeable membranes of the adjacent liquid panels of the LAMEE can be structured and configured to be permeable to water, but not to other constituents that may be present in the cooling liquid. Thus, generally anything in the cooling liquid in a gas phase can pass through the membranes and generally anything in a liquid or solid phase cannot pass through the membranes. Such membranes can include porous, micro-porous, non-porous, and selectively permeable membranes, as examples. In examples, the membranes of example absorber-evaporator devices in accordance with this disclosure can be a micro-porous structure membrane formed as a thin film of a low surface energy polymer such as PTFE, polypropylene or polyethylene. The hydrophobic membrane resists penetration by the liquid due to surface tension, while freely allowing the transfer of gases, including water vapor, through the membrane pores. In examples, the membranes can be about 20 microns thick with a mean pore size of 0.1-0.2 micron.

Membrane exchangers may have some advantages over other types of evaporative coolers. For example, the LAMEE may eliminate or mitigate maintenance requirements and concerns of conventional cooling towers or other systems including direct-contact evaporation devices, where the water is in direct contact with the air stream that is saturated by the evaporated water. For example, the membrane barriers of the LAMEE inhibit or prohibit the transfer of contaminants and micro-organisms between the air and the liquid stream, as well as inhibiting or prohibiting the transfer of solids between the water and air.

In an example, the cooling (evaporative) liquid in EC 804 can be water or predominantly water. It is recognized that other types of evaporative cooling liquids can be used in combination with water or as an alternative to water in the other conditioning systems described herein, including, for example, liquid desiccants.

LDAC 806 includes absorber-evaporator (AE) 822, regenerator 824, and desiccant cooler 826. LDAC 806 can be substantially similar to LDAC unit 100 of the example of FIG. 1 and/or LDAC 606 of the example of FIG. 6 (as LDAC 806 includes a liquid-to-air desiccant cooler 826). The components, structures, configuration, functions, etc. of LDAC 806 can therefore be the same as or substantially similar to that described in detail above with reference to LDAC unit 100 and/or LDAC 606. Additionally, AE 822 can be substantially similar to AE 200 of the example of FIG. 2. The components, structures, configuration, functions, etc. of AE 822 can therefore be the same as or substantially similar to that described in detail above with reference to AE 200.

Conditioning system 800 and LDAC 806 include and/or are connected by a number of liquid circuits. EC 804 is fluidically connected to LDAC 806 via cooling liquid supply circuit 814 and cooling liquid return circuit 816. Cooling liquid leaves EC 804 via liquid outlet 818 and flows through cooling liquid supply circuit 814 to AE 822 of LDAC 806. Cooling liquid leaves AE 822 and returns to liquid inlet 820 of EC 804 via cooling liquid return circuit 816. And, in some operational modes, supply-return bridging circuit 828 causes the cooling liquid leaving EC 804 via liquid outlet 818 to bypass LDAC 806 and be recycled/returned directly back to liquid inlet 820 of EC 804. Additionally, LDAC 806 includes liquid desiccant circuit 830 by which it recirculates liquid desiccant through the system. The routing of cooling liquid from outlet 818 to inlet 820 of EC 804 whether through or bypassing LDAC 806 and the routing of liquid desiccant through LDAC 806 can be implemented using a variety of types and number of devices or other techniques, including various number and types of valves, tanks or other reservoirs, and pumps.

In examples, conditioning system 800 can cool the process air to the set point temperature and at an acceptable level of humidity employing EC 804 without trim cooling from LDAC 806. Additionally, conditioning system 800 can cool the process air to the set point temperature and at an acceptable level of humidity employing EC 804 with LDAC 806 providing trim cooling to the cooling liquid circulating through EC 804, for example to reduce the likelihood or prevent the supply air from becoming oversaturated.

In examples in which conditioning system 800 cools the process air to the set point temperature and at an acceptable level of humidity employing EC 804 without trim cooling from LDAC 806, EC 804 may be operated in an adiabatic mode in which the temperature of the cooling liquid circulating through EC 804 remains approximately equal between inlet 820 and outlet 818. Supply-return bridging circuit 828 can be actuated to cause the cooling liquid leaving EC 804 via liquid outlet 818 to bypass LDAC 806 and be recycled/returned directly back to liquid inlet 820 of EC 804. Additionally, the components of LDAC 806 including AE 822, regenerator 824, and desiccant cooler 826 can be deactivated.

In examples in which conditioning system 800 cools the process air to the set point temperature and at an acceptable level of humidity employing EC 804 with LDAC 806 providing trim cooling to the cooling liquid circulating through EC 804, supply-return bridging circuit 828 can be deactivated/not actuated to effectively separate cooling liquid supply circuit 814 and cooling liquid return circuit 816. EC 804 may evaporatively cool the process air to the set point temperature employing cooling liquid that is cooled by LDAC 806 and delivered to inlet 820 of EC 804. In this mode of operation, the temperature of the cooling liquid leaving EC 804 via outlet 818 is greater than (in some cases substantially greater) the temperature of the cooling liquid delivered by LDAC 806 to inlet 820 of EC 804. Additionally, with the trim liquid cooling provided by LDAC 806, EC 804 is able even in peak ambient conditions to evaporatively cool the process air to the set point temperature without oversaturating the air supplied to the enclosed space via air outlet 810 of process plenum 802.

Similar to that previously described with respect to the LDAC units 100, 306, 406, 506 & 606, the LDAC unit 806 includes a regenerator 824 that is structured and configured to receive dilute desiccant from the AE 822, draw water out of the desiccant, and channel the concentrated (regenerated/restored) desiccant and recovered water out of the device. For example, regenerator 824 can be configured to receive the liquid desiccant at a regenerator inlet and separate the water and desiccant into a concentrated desiccant stream, which exits regenerator 824 at a regenerator outlet, and a water stream, which exits the regenerator 824 at recovered water outlet 832. The water recovered by regenerator 824 can be used as a pure water supply by other components of the conditioning system such as to reduce overall water consumption of the system, and/or stored in a tank or other reservoir. For example, as depicted in FIG. 8, recovered water exiting the recovered water outlet 832 can be directed to return to the cooling liquid supply circuit 814 as makeup water. In another example, recovered water exiting the recovered water outlet 832 can be directed to a reservoir to be, e.g., conditioned or stored before being injected back into conditioning system 300 as makeup water. Here, the water recovered by regenerator 824 is used to mitigate or eliminate net water loss from the cooling liquid return circuit 816 resulting from, e.g., evaporative cooling by the AE 822.

Example conditioning systems of the present disclosure can include an optional makeup water source 834 for supplemental water supply to the cooling liquid. In an example, the makeup water source 834 is an atmospheric water harvesting unit which uses, e.g., a liquid desiccant dryer to recover water from the outside air or process air from a data center. Another example makeup water source 834 is blowdown water from a conditioning system. In some conditioning systems including evaporative cooling, blowdown water must be discharged in order to avoid excessive mineral buildup resulting from water vapor being separated out of utility water supplied to the system. This blowdown water can be distilled using, e.g., membrane distillation or reverse-osmosis filtration and used as makeup water. Other example makeup water sources 834 can be any other source of reclaimed water such as distilled or purified rainwater or environmental (e.g., river, lake) water.

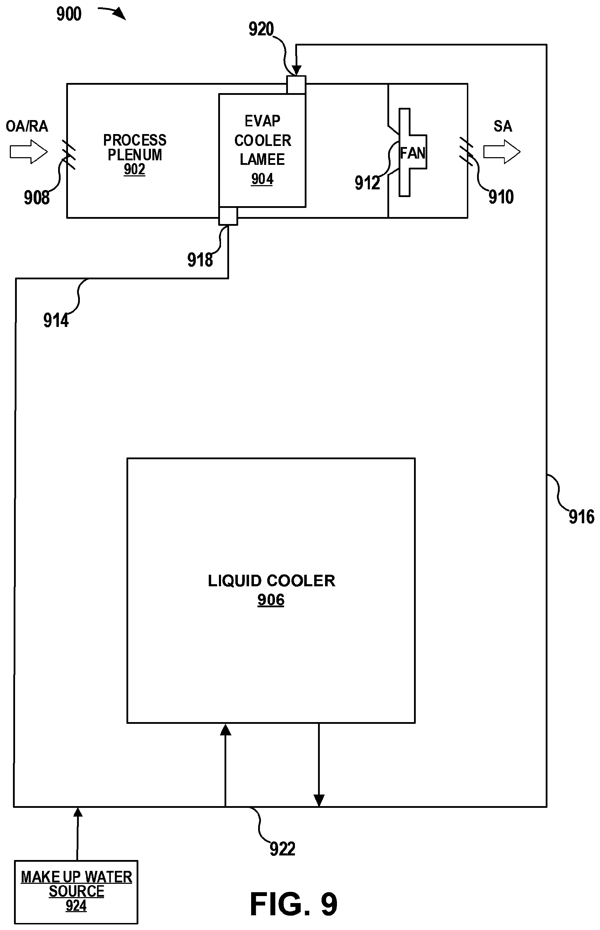

FIG. 9 schematically depicts example conditioning system 900 in accordance with examples of this disclosure. Conditioning system 900 is an air conditioning system in which outdoor and/or return air (OA/RA) from an enclosed space is channeled through process plenum 902, conditioned and supplied to the space as conditioned supply air (SA). For example, conditioning system can be configured to cool supply air to a predetermined set point temperature and deliver the cooled supply air to the enclosed space.

Similar to that described above with respect to conditioning system 800, conditioning system 900 includes evaporative cooler (EC) 904. EC 904 can be a variety of different types of evaporative cooling devices, including a LAMEE. In this system configuration, EC 904 is a direct evaporative cooler, which functions to directly modulate the conditions of the enclosed space using the process supply air by evaporatively cooling the air with a cooling liquid circulating through EC 904. It is possible for some evaporative coolers to be implemented as the primary conditioning component operating adiabatically in such direct evaporative cooling applications. However, due to the manner in which evaporative coolers condition the supply air, e.g., through evaporation sufficient to cool the air to the set point temperature, in hotter and more humid ambient conditions, operating the evaporative cooler adiabatically may deliver oversaturated (relative humidity above acceptable levels) supply air to the enclosed space.

Example conditioning system 900 therefore employs EC 904 in a direct evaporative cooling system configuration that includes liquid cooler (LC) 906 to provide supplemental (trim) cooling to the cooling liquid flowing through the evaporative cooler. With the added liquid cooling supplied by LC 906, EC 904 can be operated in an adiabatic-like mode in peak conditions without oversaturating the supply air delivered to the enclosed space.

In FIG. 9, conditioning system 900 includes process plenum 902 with air inlet 908 and air outlet 910, EC 904, LC 906, fan 912, cooling liquid supply circuit 914, and cooling liquid return circuit 916. Process air plenum 902 of conditioning system 900 includes air inlet 908 and air outlet 910 through which fan 912 can cause a process air (e.g., OA or RA) stream to flow through EC 902. In examples, one or more filters (not shown) can be arranged inside process plenum 902 at one or more locations at and/or between inlet 908 and outlet 810.

The process air entering plenum 902 can pass through EC 904. EC 904 can be configured to condition the cooling liquid and/or the process air passing there through using the cooling liquid (may also be referred to in reference to operation of evaporative coolers as an evaporative liquid). EC 904 can use the cooling potential in both the air and the evaporative liquid to reject heat. In an example, as process air flows through EC 904, the cooling liquid, or both the process air and the cooling liquid, can be cooled to a temperature approaching the wet bulb (WB) temperature of the air entering plenum 902. In this system configuration, due to the evaporative cooling process in EC 904, a temperature of the process air exiting EC 904 and delivered as supply air via outlet 910 can be less than a temperature of the process air entering plenum 902 via inlet 908. In examples, a temperature of the cooling liquid at outlet 918 of EC 904 is greater than a temperature of the cooling liquid at inlet 920. In some cases, a temperature reduction of the process air can be significant, whereas in other cases, the temperature reduction can be minimal. Additionally, a temperature increase of the cooling liquid can range from approximately zero to minimal or significant.

Similar to that previously described with respect to EC 804, EC 904 can be any type of evaporative cooler configured to exchange energy between an air stream and a cooling liquid through evaporation of a portion of the liquid into the air. Evaporative coolers can include direct-contact evaporation devices in which the working air stream and the liquid water (or other liquid) stream that is evaporated into the air to drive heat transfer are in direct contact with one another. In what is sometimes referred to as "open" direct-contact evaporation devices, the liquid water may be sprayed or misted directly into the air stream, or, alternatively the water is sprayed onto a filler material or wetted media across which the air stream flows. As the unsaturated air is directly exposed to the liquid water, the water evaporates into the air, and, in some cases, the water is cooled.

Such direct-contact evaporation devices can also include what is sometimes referred to as a closed circuit device. Unlike the open direct-contact evaporative device, the closed system has two separate liquid circuits. One is an external circuit in which water is recirculated on the outside of the second circuit, which is tube bundles (closed coils) connected to the process for the hot liquid being cooled and returned in a closed circuit. Air is drawn through the recirculating water cascading over the outside of the hot tubes, providing evaporative cooling similar to an open circuit. In operation the heat flows from the internal liquid circuit, through the tube walls of the coils, to the external circuit and then by heating of the air and evaporation of some of the water, to the atmosphere.

These different types of evaporative coolers can also be packaged and implemented in specific types of systems. For example, a cooling tower can include an evaporative cooling device such as those described above. A cooling tower is a device that processes working air and water streams in generally a vertical direction and that is designed to reject waste heat to the atmosphere through the cooling of a water stream to a lower temperature. Cooling towers can transport the air stream through the device either through a natural draft or using fans to induce the draft or exhaust of air into the atmosphere. Cooling towers include or incorporate a direct-contact evaporation device/components, as described above.

Examples of evaporative coolers usable in the conditioning systems of the present application can also include other types of evaporative cooling devices, including liquid-to-air membrane energy exchangers. Unlike direct-contact evaporation devices, a liquid-to-air membrane energy exchanger (LAMEE) separates the air stream and the liquid water stream by a permeable membrane, which allows water to evaporate on the liquid water stream side of the membrane and water vapor molecules to permeate through the membrane into the air stream. The water vapor molecules permeated through the membrane saturate the air stream and the associated energy caused by the evaporation is transferred between the liquid water stream and the air stream by the membrane.

In at least some examples in which EC 904 is a LAMEE, the LAMEE can include a stack of alternating air and liquid channels, through which scavenger air and the cooling liquid flow and in which each air channel is separated from a pair of adjacent liquid channels by permeable membranes. The liquid channels may be formed as polymer liquid panels, each of which direct the cooling liquid through a plurality of liquid flow channels enclosed by permeable membranes affixed to opposing faces of the liquid panel. In examples, such a liquid panel can in include a plurality of liquid inlets and liquid outlets that are connected by a plurality of liquid flow channels. Additionally, in examples, each liquid inlet and each liquid outlet can direct cooling liquid into and out of a plurality of liquid flow channels.

Example LAMEE ECs in accordance with this disclosure can employ permeable membranes to separate the cooling liquid and air flows/streams there through. The permeable membranes of the adjacent liquid panels of the LAMEE can be structured and configured to be permeable to water, but not to other constituents that may be present in the cooling liquid. Thus, generally anything in the cooling liquid in a gas phase can pass through the membranes and generally anything in a liquid or solid phase cannot pass through the membranes. Such membranes can include porous, micro-porous, non-porous, and selectively permeable membranes, as examples. In examples, the membranes of example absorber-evaporator devices in accordance with this disclosure can be a micro-porous structure membrane formed as a thin film of a low surface energy polymer such as PTFE, polypropylene or polyethylene. The hydrophobic membrane resists penetration by the liquid due to surface tension, while freely allowing the transfer of gases, including water vapor, through the membrane pores. In examples, the membranes can be about 20 microns thick with a mean pore size of 0.1-0.2 micron.

Membrane exchangers may have some advantages over other types of evaporative coolers. For example, the LAMEE may eliminate or mitigate maintenance requirements and concerns of conventional cooling towers or other systems including direct-contact evaporation devices, where the water is in direct contact with the air stream that is saturated by the evaporated water. For example, the membrane barriers of the LAMEE inhibit or prohibit the transfer of contaminants and micro-organisms between the air and the liquid stream, as well as inhibiting or prohibiting the transfer of solids between the water and air.

In an example, the cooling (evaporative) liquid in EC 904 can be water or predominantly water. It is recognized that other types of evaporative cooling liquids can be used in combination with water or as an alternative to water in the other conditioning systems described herein, including, for example, liquid desiccants.

In an example, the LC 906 is a vapor compression cycle mechanical chiller using, e.g., synthetic refrigerants. LC 906 can also be a variety of devices configured to cool the cooling liquid, including, generally, liquid-to-air or liquid-to-liquid heat exchangers (LAHX and LLHX, respectively), chillers, dry coolers, cooling towers, adiabatic coolers, or any other type of evaporative cooler or hybrid cooler, or a combination thereof.

Conditioning system 900 and LC 906 include and/or are connected by a number of liquid circuits. EC 904 is fluidically connected to LC 906 via cooling liquid supply circuit 914 and cooling liquid return circuit 916. Cooling liquid leaves EC 904 via liquid outlet 918 and flows through cooling liquid supply circuit 914 to LC 906. Cooling liquid leaves LC 906 and returns to liquid inlet 920 of EC 904 via cooling liquid return circuit 916. And, in some operational modes, supply-return bridging circuit 922 causes the cooling liquid leaving EC 904 via liquid outlet 918 to bypass LC 906 and be recycled/returned directly back to liquid inlet 920 of EC 904. Additionally, LC906 includes liquid desiccant circuit 930 by which it recirculates liquid desiccant through the system. The routing of cooling liquid from outlet 918 to inlet 920 of EC 904 whether through or bypassing LC 906 and the routing of liquid desiccant through LC 906 can be implemented using a variety of types and number of devices or other techniques, including various number and types of valves, tanks or other reservoirs, and pumps.

In examples, conditioning system 900 can cool the process air to the set point temperature and at an acceptable level of humidity employing EC 904 without trim cooling from LC 906. Additionally, conditioning system 900 can cool the process air to the set point temperature and at an acceptable level of humidity employing EC 904 with LC 906 providing trim cooling to the cooling liquid circulating through EC 904, for example to reduce the likelihood or prevent the supply air from becoming oversaturated.

In examples in which conditioning system 900 cools the process air to the set point temperature and at an acceptable level of humidity employing EC 904 without trim cooling from LC 906, EC 904 may be operated in an adiabatic mode in which the temperature of the cooling liquid circulating through EC 904 remains approximately equal between inlet 920 and outlet 918. Supply-return bridging circuit 922 can be actuated to cause the cooling liquid leaving EC 904 via liquid outlet 918 to bypass LC 906 and be recycled/returned directly back to liquid inlet 920 of EC 904. Additionally, the components or functions of LC 906 can be deactivated.

In examples in which conditioning system 900 cools the process air to the set point temperature and at an acceptable level of humidity employing EC 904 with LC 906 providing trim cooling to the cooling liquid circulating through EC 904, supply-return bridging circuit 922 can be deactivated/not actuated to effectively separate cooling liquid supply circuit 914 and cooling liquid return circuit 916. EC 904 may evaporatively cool the process air to the set point temperature employing cooling liquid that is cooled by LC 906 and delivered to inlet 920 of EC 904. In this mode of operation, the temperature of the cooling liquid leaving EC 904 via outlet 918 is greater than (in some cases substantially greater) the temperature of the cooling liquid delivered by LC 906 to inlet 920 of EC 904. Additionally, with the trim liquid cooling provided by LC 906, EC 904 is able even in peak ambient conditions to evaporatively cool the process air to the set point temperature without oversaturating the air supplied to the enclosed space via air outlet 910 of process plenum 802.

Example conditioning systems of the present disclosure can include an optional makeup water source 924 for supplemental water supply to the cooling liquid. In an example, the makeup water source 924 is an atmospheric water harvesting unit which uses, e.g., a liquid desiccant dryer to recover water from the outside air or process air from a data center. Another example makeup water source 924 is blowdown water from a conditioning system. In some conditioning systems including evaporative cooling, blowdown water must be discharged in order to avoid excessive mineral buildup resulting from water vapor being separated out of utility water supplied to the system. This blowdown water can be distilled using, e.g., membrane distillation or reverse-osmosis filtration and used as makeup water. Other example makeup water sources 924 can be any other source of reclaimed water such as distilled or purified rainwater or environmental (e.g., river, lake) water.

The above description is intended to be illustrative, and not restrictive. For example, the above-described examples (or one or more aspects thereof) may be used in combination with each other. Other embodiments can be used, such as by one of ordinary skill in the art upon reviewing the above description.

The above detailed description includes references to the accompanying drawings, which form a part of the detailed description. The drawings show, by way of illustration, specific embodiments in which the invention can be practiced. These embodiments are also referred to herein as "examples." Such examples can include elements in addition to those shown or described. However, the present inventors also contemplate examples in which only those elements shown or described are provided. Moreover, the present inventors also contemplate examples using any combination or permutation of those elements shown or described (or one or more aspects thereof), either with respect to a particular example (or one or more aspects thereof), or with respect to other examples (or one or more aspects thereof) shown or described herein.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In this document, the terms "including" and "in which" are used as the plain-English equivalents of the respective terms "comprising" and "wherein." Also, in the following claims, the terms "including" and "comprising" are open-ended, that is, a system, device, article, composition, formulation, or process that includes elements in addition to those listed after such a term in a claim are still deemed to fall within the scope of that claim. Moreover, in the following claims, the terms "first," "second," and "third," etc. are used merely as labels, and are not intended to impose numerical requirements on their objects.

Method examples described herein can be machine or computer-implemented at least in part. Some examples can include a computer-readable medium or machine-readable medium encoded with instructions operable to configure an electronic device to perform methods as described in the above examples. An implementation of such methods can include code, such as microcode, assembly language code, a higher-level language code, or the like. Such code can include computer readable instructions for performing various methods. The code may form portions of computer program products. Further, the code can be tangibly stored on one or more volatile or non-volatile tangible computer-readable media, such as during execution or at other times. Examples of these tangible computer-readable media can include, but are not limited to, hard disks, removable magnetic disks, removable optical disks (e.g., compact disks and digital video disks), magnetic cassettes, memory cards or sticks, random access memories (RAMs), read only memories (ROMs), and the like.

Examples, as described herein, may include, or may operate on, logic or a number of components, modules, or mechanisms. Modules may be hardware, software, or firmware communicatively coupled to one or more processors in order to carry out the operations described herein. Modules may hardware modules, and as such modules may be considered tangible entities capable of performing specified operations and may be configured or arranged in a certain manner. In an example, circuits may be arranged (e.g., internally or with respect to external entities such as other circuits) in a specified manner as a module. In an example, the whole or part of one or more computer systems (e.g., a standalone, client or server computer system) or one or more hardware processors may be configured by firmware or software (e.g., instructions, an application portion, or an application) as a module that operates to perform specified operations. In an example, the software may reside on a machine-readable medium. In an example, the software, when executed by the underlying hardware of the module, causes the hardware to perform the specified operations. Accordingly, the term hardware module is understood to encompass a tangible entity, be that an entity that is physically constructed, specifically configured (e.g., hardwired), or temporarily (e.g., transitorily) configured (e.g., programmed) to operate in a specified manner or to perform part or all of any operation described herein. Considering examples in which modules are temporarily configured, each of the modules need not be instantiated at any one moment in time. For example, where the modules comprise a general-purpose hardware processor configured using software; the general-purpose hardware processor may be configured as respective different modules at different times. Software may accordingly configure a hardware processor, for example, to constitute a particular module at one instance of time and to constitute a different module at a different instance of time. Modules may also be software or firmware modules, which operate to perform the methodologies described herein.

The above description is intended to be illustrative, and not restrictive. For example, the above-described examples (or one or more aspects thereof) may be used in combination with each other. Other embodiments can be used, such as by one of ordinary skill in the art upon reviewing the above description. Also, in the above Detailed Description, various features may be grouped together to streamline the disclosure. This should not be interpreted as intending that an unclaimed disclosed feature is essential to any claim. Rather, inventive subject matter may lie in less than all features of a particular disclosed embodiment. Thus, the following claims are hereby incorporated into the Detailed Description, with each claim standing on its own as a separate embodiment, and it is contemplated that such embodiments can be combined with each other in various combinations or permutations. The scope of the invention is defined by the claims.

## Claims

1. An absorber-evaporator (200) comprising:
a cooling liquid channel (224) through which a cooling liquid is configured to flow;
a liquid desiccant channel (222) through which a liquid desiccant is configured to flow;
an air-gap cell (206) disposed between the cooling liquid channel (224) and the liquid desiccant channel (222);
a first permeable membrane (212) disposed between the liquid desiccant channel (222) and the air-gap cell (206); and
a second permeable membrane (218) disposed between the cooling liquid channel (224) and the air-gap cell (206), wherein:
the cooling liquid channel (224)
comprises a plurality of evaporation chambers (204) fluidically connected to one another in series and defining a cooling liquid channel flow path along which the cooling liquid flows through the cooling liquid channel (224);
**characterized in that**
the air-gap cell comprises a plurality of air-gap chambers (206) each of which corresponds with one of the plurality of evaporation chambers (204) and one of a plurality of absorption chambers (202) to define an evaporation stage in which vapor separated from the cooling liquid passes from the evaporation chamber (204) through the first: permeable membrane ; (212) and the second permeable (218) via the air-gap chamber (206) to be absorbed by the liquid desiccant.

2. The absorber-evaporator of claim 1, wherein:
the first and second permeable membranes (212, 218) are configured to permeate gas and vapor and to prevent permeation of liquids and solids.

3. The absorber-evaporator of claim 1, wherein:
the cooling liquid channel flow path is a serpentine flow path (224).

4. The absorber-evaporator of claim 3, wherein:
the liquid desiccant channel comprises a plurality of absorption chambers fluidically connected to one another in series and defining a liquid desiccant channel flow path along which the liquid desiccant flows through the liquid dessicant channel.

5. The absorber-evaporator of claim 4, wherein:
the liquid desiccant channel flow path is a serpentine flow path.

6. The absorber-evaporator of claim 5, wherein:
the cooling liquid flows through the serpentine flow path (224) of the cooling liquid channel in a direction opposite a direction of flow of the liquid desiccant flowing through the serpentine flow path of the liquid desiccant channel.

7. The absorber-evaporator of claim 4, wherein:
the serpentine flow path of the liquid desiccant channel directs the liquid desiccant in first and second opposite directions through adjacent absorption chambers of the plurality of absorption chambers and in a third direction between adjacent absorption chambers of the plurality of absorption chambers; and
the third direction is perpendicular to the first and second opposing directions.

8. The absorber-evaporator of claim 3, wherein:
the serpentine flow path of the cooling liquid channel directs the cooling liquid in first and second opposite directions through adjacent evaporation chambers of the plurality of evaporation chambers and in a third direction between adjacent evaporation chambers of the plurality of evaporation chambers; and
the third direction is perpendicular to the first and second opposing directions.

9. The absorber-evaporator of claim 1, wherein:
the plurality of air-gap chambers of the air-gap cell are configured such that one or more parameters in each of the plurality of air-gap chambers are independently controllable.

10. The absorber-evaporator of claim 1, wherein:
the one or more parameters comprise air pressure.

11. The absorber-evaporator of claim 1, wherein:
the plurality of evaporation chambers of the cooling liquid channel are configured such that one or more parameters in each of the plurality of evaporation chambers are independently controllable.

12. The absorber-evaporator of claim 1, wherein:
the plurality of absorption chambers of the liquid desiccant channel are configured such that one or more parameters in each of the plurality of absorption chambers are independently controllable.

13. The absorber-evaporator of claim 1, wherein:
a vapor pressure of the cooling liquid in the cooling liquid channel is greater than a vapor pressure of the liquid desiccant in the liquid desiccant channel.

14. The absorber-evaporator of claim 1, wherein:
pressure in the air-gap cell is negative.

## Patentansprüche

1. Absorber-Verdampfer (200) umfassend:
einen Kühlflüssigkeitskanal (224), durch den eine Kühlflüssigkeit fließen soll;
einen Flüssigtrockenmittelkanal (222), durch den ein Flüssigtrockenmittel fließen soll;
eine Luftspaltzelle (206), die zwischen dem Kühlflüssigkeitskanal (224) und dem Flüssigtrockenmittelkanal (222) angeordnet ist;
eine erste durchlässige Membran (212), die zwischen dem Flüssigtrockenmittelkanal (222) und der Luftspaltzelle (206) angeordnet ist; und
eine zweite durchlässige Membran (218), die zwischen dem Kühlflüssigkeitskanal (224) und der Luftspaltzelle (206) angeordnet ist, wobei:
der Kühlflüssigkeitskanal (224) eine Vielzahl von Verdampfungskammern (204) umfasst, die fluidisch in Reihe miteinander verbunden sind und einen Kühlflüssigkeitskanal-Strömungsweg definieren, entlang dessen die Kühlflüssigkeit durch den Kühlflüssigkeitskanal (224) fließt; **dadurch gekennzeichnet, dass**
die Luftspaltzelle eine Vielzahl von Luftspaltkammern (206) umfasst, von denen jede einer der Vielzahl von Verdampfungskammern (204) und einer einer Vielzahl von Absorptionskammern (202) entspricht, um eine Verdampfungsstufe zu definieren, in der der vom Kühlwasser abgetrennte Dampf aus der Verdampfungskammer (204) durch die erste durchlässige Membran (212) und die zweite durchlässige Membran (218) über die Luftspaltkammer (206) gelangt, um vom Flüssigtrockenmittel absorbiert zu werden.

2. Absorber-Verdampfer nach Anspruch 1, wobei:
die erste und zweite durchlässige Membran (212, 218) so konfiguriert sind, dass sie Gas und Dampf durchlassen und einen Durchlass von Flüssigkeiten und Feststoffen verhindern.

3. Absorber-Verdampfer nach Anspruch 1, wobei:
der Kühlflüssigkeitskanal-Strömungsweg ein serpentinenförmiger Strömungsweg (224) ist.

4. Absorber-Verdampfer nach Anspruch 3, wobei:
der Flüssigtrockenmittelkanal eine Vielzahl von Absorptionskammern umfasst, die fluidisch in Reihe miteinander verbunden sind und einen Flüssigtrockenmittelkanal-Strömungsweg definieren, entlang dessen das Flüssigtrockenmittel durch den Flüssigtrockenmittelkanal fließt.

5. Absorber-Verdampfer nach Anspruch 4, wobei:
der Flüssigtrockenmittelkanal-Strömungsweg ein serpentinenförmiger Strömungsweg ist.

6. Absorber-Verdampfer nach Anspruch 5, wobei:
die Kühlflüssigkeit durch den serpentinenförmigen Strömungsweg (224) des Kühlflüssigkeitskanals in einer Richtung fließt, die einer Strömungsrichtung des Flüssigtrockenmittels, das durch den serpentinenförmigen Strömungsweg des Flüssigtrockenmittelkanals fließt, entgegengesetzt ist.

7. Absorber-Verdampfer nach Anspruch 4, wobei:
der serpentinenförmige Strömungsweg des Flüssigtrockenmittelkanals das Flüssigtrockenmittel in einer ersten und einer zweiten entgegengesetzten Richtung durch benachbarte Absorptionskammern der Vielzahl von Absorptionskammern und in einer dritten Richtung zwischen benachbarten Absorptionskammern der Vielzahl von Absorptionskammern lenkt; und
die dritte Richtung senkrecht zur ersten und zweiten entgegengesetzten Richtung steht.

8. Absorber-Verdampfer nach Anspruch 3, wobei:
der serpentinenförmige Strömungsweg des Kühlflüssigkeitskanals die Kühlflüssigkeit in einer ersten und einer zweiten entgegengesetzten Richtung durch benachbarte Verdampfungskammern der Vielzahl von Verdampfungskammern und in einer dritten Richtung zwischen benachbarten Verdampfungskammern der Vielzahl von Verdampfungskammern lenkt; und
die dritte Richtung senkrecht zur ersten und zweiten entgegengesetzten Richtung steht.

9. Absorber-Verdampfer nach Anspruch 1, wobei:
die Vielzahl von Luftspaltkammern der Luftspaltzelle so konfiguriert sind, dass ein oder mehrere Parameter in jeder der Vielzahl von Luftspaltkammern unabhängig voneinander steuerbar sind.

10. Absorber-Verdampfer nach Anspruch 1, wobei:
der eine oder die mehreren Parameter Luftdruck umfassen.

11. Absorber-Verdampfer nach Anspruch 1, wobei:
die Vielzahl von Verdampfungskammern des Kühlflüssigkeitskanals so konfiguriert sind, dass ein oder mehrere Parameter in jeder der Vielzahl von Verdampfungskammern unabhängig voneinander steuerbar sind.

12. Absorber-Verdampfer nach Anspruch 1, wobei:
die Vielzahl von Absorptionskammern des Flüssigtrockenmittelkanals so konfiguriert sind, dass ein oder mehrere Parameter in jeder der Vielzahl von Absorptionskammern unabhängig voneinander steuerbar sind.

13. Absorber-Verdampfer nach Anspruch 1, wobei:
ein Dampfdruck der Kühlflüssigkeit im Kühlflüssigkeitskanal größer als ein Dampfdruck des Flüssigtrockenmittels im Flüssigtrockenmittelkanal ist.

14. Absorber-Verdampfer nach Anspruch 1, wobei:
Druck in der Luftspaltzelle negativ ist.

## Revendications

1. Absorbeur-évaporateur (200) comprenant :
un canal de liquide de refroidissement (224), à travers lequel un liquide de refroidissement est destiné à s'écouler ;
un canal de déshydratant liquide (222), à travers lequel un déshydratant liquide est destiné à
s'écouler ;
une cellule d'entrefer (206) disposée entre le canal de liquide de refroidissement (224) et le canal de déshydratant liquide (222) ;
une première membrane perméable (212) disposée entre le canal de déshydratant liquide (222) et la cellule d'entrefer (206) ; et
une seconde membrane perméable (218) disposée entre le canal de liquide de refroidissement (224) et la cellule d'entrefer (206), dans lequel :
le canal de liquide de refroidissement (224) comprend une pluralité de chambres d'évaporation (204) reliées fluidiquement entre elles en série et définissant un chemin d'écoulement de canal du liquide de refroidissement, le long duquel ce dernier circule à travers le canal de liquide de refroidissement (224) ; **caractérisé en ce que**
la cellule d'entrefer comprend une pluralité de chambres à entrefer (206), dont chacune correspond à l'une de la pluralité de chambres d'évaporation (204) et à l'une d'une pluralité de chambres d'absorption (202) pour définir un étage d'évaporation, dans lequel la vapeur séparée du liquide de refroidissement passe de la chambre d'évaporation (204) à travers la première membrane perméable (212) et la seconde membrane perméable (218) via la chambre à entrefer (206) pour être absorbée par le déshydratant liquide.

2. Absorbeur-évaporateur selon la revendication 1, dans lequel :
les première et seconde membranes perméables (212, 218) sont configurées pour laisser passer les gaz et les vapeurs et pour empêcher la perméation des liquides et des solides.

3. Absorbeur-évaporateur selon la revendication 1, dans lequel :
le chemin d'écoulement de canal de liquide de refroidissement est un chemin d'écoulement serpentin (224).

4. Absorbeur-évaporateur selon la revendication 3, dans lequel :
le canal de déshydratant liquide comprend une pluralité de chambres d'absorption reliées fluidiquement entre elles en série et définissant un chemin d'écoulement de canal de déshydratant liquide, le long duquel le déshydratant liquide s'écoule à travers le canal de déshydratant liquide.

5. Absorbeur-évaporateur selon la revendication 4, dans lequel :
le chemin d'écoulement de canal de déshydratant liquide est un chemin serpentin.

6. Absorbeur-évaporateur selon la revendication 5, dans lequel :
le liquide de refroidissement s'écoule à travers le chemin d'écoulement serpentin (224) du canal de liquide de refroidissement dans une direction opposée à celle de l'écoulement du déshydratant liquide s'écoulant à travers le chemin d'écoulement serpentin du canal de déshydratant liquide.

7. Absorbeur-évaporateur selon la revendication 4, dans lequel :
le chemin d'écoulement serpentin du canal de déshydratant liquide dirige le déshydratant liquide dans une première et une deuxième direction opposée à travers les chambres d'absorption adjacentes de la pluralité de chambres d'absorption, et dans une troisième direction entre les chambres d'absorption adjacentes de la pluralité de chambres d'absorption ; et
la troisième direction est perpendiculaire aux première et deuxième directions opposées.

8. Absorbeur-évaporateur selon la revendication 3, dans lequel :
le chemin d'écoulement serpentin du canal de liquide de refroidissement dirige ce dernier dans une première et une deuxième direction opposée à travers les chambres d'évaporation adjacentes de la pluralité de chambres d'évaporation, et dans une troisième direction entre les chambres d'évaporation adjacentes de la pluralité de chambres d'évaporation ; et
la troisième direction est perpendiculaire aux première et deuxième directions opposées.

9. Absorbeur-évaporateur selon la revendication 1, dans lequel :
la pluralité de chambres à entrefer de la cellule d'entrefer sont configurées de sorte qu'un ou plusieurs paramètres dans chacune de la pluralité de chambres à entrefer soient commandables indépendamment.

10. Absorbeur-évaporateur selon la revendication 1, dans lequel :
les un ou plusieurs paramètres comprennent la pression de l'air.

11. Absorbeur-évaporateur selon la revendication 1, dans lequel :
la pluralité de chambres d'évaporation du canal de liquide de refroidissement sont configurées de sorte qu'un ou plusieurs paramètres dans chacune de la pluralité de chambres d'évaporation soient commandables indépendamment.

12. Absorbeur-évaporateur selon la revendication 1, dans lequel :
la pluralité de chambres d'absorption du canal de déshydratant liquide sont configurées de sorte qu'un ou plusieurs paramètres dans chacune de la pluralité de chambres d'absorption soient commandables indépendamment.

13. Absorbeur-évaporateur selon la revendication 1, dans lequel :
la pression de vapeur du liquide de refroidissement dans le canal de liquide de refroidissement est supérieure à la pression de vapeur du déshydratant liquide dans le canal de déshydratant liquide.

14. Absorbeur-évaporateur selon la revendication 1, dans lequel :
la pression dans la cellule d'entrefer est négative.
